(19) Europäisches Patentamt
European Patent Office
Office européen des brevets

(11) **EP 4 391 399 A1**

(12) **EUROPÄISCHE PATENTANMELDUNG**

(43) Veröffentlichungstag:
26.06.2024  Patentblatt 2024/26

(21) Anmeldenummer: 23219215.3

(22) Anmeldetag: 21.12.2023

(51) Internationale Patentklassifikation (IPC):
$H04B\ 5/26$ (2024.01)    $H04B\ 5/48$ (2024.01)
$H04B\ 5/77$ (2024.01)    $H04B\ 5/79$ (2024.01)

(52) Gemeinsame Patentklassifikation (CPC):
H04B 5/26; H04B 5/48; H04B 5/77; H04B 5/79

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **22.12.2022  DE 102022214355**

(71) Anmelder:
• **Fraunhofer-Gesellschaft zur Förderung
der angewandten Forschung e.V.
80686 München (DE)**
• **Technische Hochschule Nuernberg
Georg-Simon-Ohm
90489 Nuernberg (DE)**

(72) Erfinder:
• **KILIAN, Gerd
91058 Erlangen (DE)**
• **WORM, Johannes
91058 Erlangen (DE)**
• **ERETH, Stefan
91058 Erlangen (DE)**
• **LAUTERBACH, Thomas
90489 Nürnberg (DE)**
• **DRÄGER, Tobias
91058 Erlangen (DE)**

(74) Vertreter: **Schlenker, Julian et al
Schoppe, Zimmermann, Stöckeler
Zinkler, Schenk & Partner mbB
Patentanwälte
Radlkoferstraße 2
81373 München (DE)**

(54) **SENDE-/EMPFANGSANORDNUNG ZUM SENDEN/EMPFANGEN VON MAGNETISCHEN
SIGNALEN**

(57)  Ausführungsbeispiele schaffen eine Sende-/Empfangsanordnung zum Senden/Empfangen von magnetischen Signalen, wobei die Sende-/Empfangsanordnung einen Mikrocontroller und einen elektromagnetischen Schwingkreis aufweist, wobei der Mikrocontroller konfiguriert ist, um, in einem Sendemodus,
- den elektromagnetischen Schwingkreis in Serienresonanz zu betreiben, und
- ein erstes Signal zum Ansteuern des elektromagnetischen Schwingkreis zu generieren und den elektromagnetischen Schwingkreis mit dem generierten ersten Signal anzusteuern, um mit dem elektromagnetischen Schwingkreis ein erstes magnetisches Signal zu erzeugen, das erste Daten trägt,
wobei der Mikrocontroller konfiguriert ist, um, in einem Empfangsmodus,
- den elektromagnetischen Schwingkreis in Parallelresonanz zu betreiben, und
- ein von dem elektromagnetischen Schwingkreis bereitgestelltes zweites Signal auszuwerten, das von einem von dem elektromagnetischen Schwingkreis detektierten zweiten magnetischen Signal abhängig ist, um zweite Daten zu empfangen.

Fig. 8

**Beschreibung**

Ausführungsbeispiele der vorliegenden Erfindung beziehen sich auf eine Sende-/Empfangsanordnung zum Senden/Empfangen von magnetischen Signalen, und im speziellen, auf eine Sende-/Empfangsanordnung, die magnetische Signale mittels eines elektromagnetischen Schwingkreises sendet und/oder empfängt. Manche Ausführungsbeispiele beziehen sich auf eine Vorrichtung zur Datenübertragung zwischen zwei Schwingkreisen.

Heutzutage sind Mobiltelefone weit verbreitet. In Mobiltelefonen sind Lautsprecher verbaut. Bei diesen handelt es sich (fast) ausschließlich um sog. elektromagnetische Lautsprecher.

Wie in [1] beschrieben wird, kann mittels eines elektromagnetischen Lautsprechers eines Mobiltelefons eine unidirektionale Datenverbindung (z. B. Konfigurationsverbindung) von dem Mobiltelefon zu einem anderen Gerät realisiert werden.

In [2] wird dann beschrieben wie durch eine Modifikation/Erweiterung eines Mobiltelefons auch eine bidirektionale Datenverbindung zwischen dem Mobiltelefon und einem anderem Gerät realisiert werden kann, während in [3] beschrieben wird, wie eine bidirektionale Datenverbindung mit einem serienmäßigen Mobiltelefon, d.h. ohne Modifikation/Erweiterung desselben, realisiert werden kann.

In [4] und [5] werden Realisierungen von abstimmbaren, bidirektionalen Datenverbindungen zwischen einem Mobiltelefon und einem anderen Gerät beschrieben.

In [6] werden Anwendungen der in [1] bis [5] beschriebenen Systeme im Heimbereich beschrieben.

In [7] wird die zur Kommunikation ohne Lautsprecher nötige Spule, ein Verfahren zur bidirektionalen Kommunikation mit höheren Datenraten und eine Anbindung an übergeordnete Geräte beschrieben.

Der vorliegenden Erfindung liegt die Aufgabe zugrunde die bestehende Situation zu verbessern, insbesondere hinschlicht Datenrate und/oder Reichweite.

Diese Aufgabe wird durch die unabhängigen Patentansprüche gelöst.

Vorteilhafte Weiterbildungen finden sich in den abhängigen Patentansprüchen.

Ausführungsbeispiele schaffen eine Sende-/Empfangsanordnung zum Senden/Empfangen von magnetischen Signalen. Die Sende-/Empfangsanordnung weist einen Mikrocontroller und einen elektromagnetischen Schwingkreis [z. B. mit einer Spule und einem Kondensator] auf, wobei der Mikrocontroller mit dem elektromagnetischen Schwingkreis [z. B. direkt] verbunden ist, wobei der Mikrocontroller konfiguriert ist, um, in einem Sendemodus,

- den elektromagnetischen Schwingkreis in Serienresonanz zu betreiben, und
- ein erstes Signal zum Ansteuern des [z. B. in Serienresonanz betriebenen] elektromagnetischen Schwingkreis zu generieren und den elektromagnetischen Schwingkreis mit dem generierten ersten Signal anzusteuern, um mit dem elektromagnetischen Schwingkreis ein erstes magnetisches Signal [z. B. magnetisches Feld] zu erzeugen, das erste Daten trägt,

wobei der Mikrocontroller konfiguriert ist, um, in einem Empfangsmodus,

- den [z. B. selben] elektromagnetischen Schwingkreis in Parallelresonanz zu betreiben, und
- ein von dem [z. B. in Parallelresonanz betriebenen] elektromagnetischen Schwingkreis bereitgestelltes zweites Signal auszuwerten, das von einem von dem elektromagnetischen Schwingkreis detektierten zweiten magnetischen Signal [z. B. magnetischen Feld] abhängig ist, um zweite Daten zu empfangen.

Bei Ausführungsbeispielen weist der elektromagnetische Schwingkreis eine Spule und einen Kondensator auf, die in Reihe geschaltet sind zwischen einem ersten Knoten und einem zweiten Knoten, wobei die Spule und der Kondensator über einen dritten Knoten miteinander verbunden sind.

Bei Ausführungsbeispielen ist der Mikrocontroller konfiguriert, um in dem Sendemodus

- an dem ersten Knoten das erste Signal anzulegen, und
- an dem zweiten Knoten ein Bezugspotential oder ein zu dem ersten Signal komplementäres Signal anzulegen.

Bei Ausführungsbeispielen ist der Mikrocontroller konfiguriert, um in dem Empfangsmodus

- an dem ersten Knoten und dem zweiten Knoten ein Bezugspotential anzulegen, und
- das zweite Signal an dem dritten Knoten abzugreifen.

Bei Ausführungsbeispielen ist ein erster Anschluss [z. B. erster Pin] des Mikrocontrollers [z. B. direkt oder über einen Verstärker [z. B. MOSFET]] mit dem ersten Knoten verbunden, wobei ein zweiter Anschluss [z. B. zweiter Pin] des Mikrocontrollers [z. B. direkt] mit dem zweiten Knoten verbunden ist.

Bei Ausführungsbeispielen ist ein dritter Anschluss [z. B. dritter Pin] des Mikrocontrollers [z. B. direkt oder über einen Komparator] mit dem dritten Knoten verbunden.

Bei Ausführungsbeispielen weist der elektromagnetische Schwingkreis ferner einen Abstimmkondensator auf, der zwischen dem dritten Knoten und einem vierten Anschluss [z. B. vierten Pin] des Mikrocontrollers geschaltet ist, wobei der Mikrocontroller konfiguriert ist, um den elektromagnetischen Schwingkreis durch Schalten des vierten Anschlusses auf einen von zumindest zwei unterschiedlichen Betriebsmodi [z. B. in dem ein definiertes Bezugspotential bereitgestellt wird und/oder in dem ein zum ersten Signal komplementäres Signal bereitgestellt wird und/oder in dem der vierte Anschluss auf einen hochohmig Zustand geschaltet wird] abzustimmen.

Bei Ausführungsbeispielen ist das erste Signal pulsweitenmoduliert.

Bei Ausführungsbeispielen ist eine Frequenz des ersten magnetischen Signals und/oder zweiten magnetischen Signals kleiner als 50 kHz.

Bei Ausführungsbeispielen weist der elektromagnetische Schwingkreis ferner ein Piezoelement auf, das zwischen dem dritten Knoten und einem fünften Anschluss [z. B. fünften Pin] des Mikrocontrollers geschaltet ist.

Bei Ausführungsbeispielen weist der elektromagnetische Schwingkreis ferner ein Piezoelement auf, das parallel zu der Spule oder dem Kondensator des elektromagnetischen Schwingkreises geschaltet ist.

Beispielsweise kann das Piezoelement zwischen dem dritten Knoten und einem fünften Anschluss [z. B. fünften Pin] des Mikrocontrollers geschaltet sein. Beispielsweise kann der Mikrocontroller konfiguriert sein, um, in dem Sendemodus, ein Bezugspotential an dem fünften Anschluss bereitzustellen, wobei der Mikrocontroller konfiguriert ist, um, in dem Empfangsmodus, den fünften Anschluss auf einen hochohmigen Zustand zu schalten.

Bei Ausführungsbeispielen ist der Mikrocontroller konfiguriert, um, in dem Sendemodus, den vierten Anschluss auf einen hochohmigen Zustand zu schalten, wobei der Mikrocontroller konfiguriert ist, um, in dem Empfangsmodus, ein Bezugspotential an dem vierten Anschluss bereitzustellen.

Beispielsweise kann ein Kapazitätswert des Abstimmkondensators mit einer Toleranz von ± 10 % einem Kapazitätswert des Piezoelements entsprechen.

Bei Ausführungsbeispielen weist der elektromagnetische Schwingkreis einen weiteren zuschaltbaren Abstimmkondensator auf, [z. B. der zwischen dem dritten Knoten und einem sechsten Anschluss [z. B. sechsten Pin] des Mikrocontrollers geschaltet ist], wobei der Mikrocontroller konfiguriert ist, um, in dem Sendemodus, den zuschaltbaren Abstimmkondensator abzuschalten [z. B. den sechsten Anschluss auf einen hochohmigen Zustand zu schalten], wobei der Mikrocontroller konfiguriert ist, um, in dem Empfangsmodus, den zuschaltbaren Abstimmkondensator zuzuschalten [z. B. ein Bezugspotential an dem sechsten Anschluss bereitzustellen].

Beispielsweise kann ein Kapazitätswert des weiteren Abstimmkondensators mit einer Toleranz von ± 10 % einem Kapazitätswert des Piezoelements entsprechen.

Bei Ausführungsbeispielen ist der Mikrocontroller konfiguriert, um eine Resonanzfrequenz des elektromagnetischen Schwingkreises über den Abstimmkondensator mit einer absichtlichen Abweichung [z. B. von ± 5 bis 15 %, oder ± 2 bis 25 %] auf eine Resonanzfrequenz eines anderen elektromagnetischen Schwingkreises, mit der der elektromagnetische Schwingkreis magnetisch gekoppelt ist, hin abzustimmen.

Weitere Ausführungsbeispiele schaffen eine Sende-/Empfangsanordnung zum Senden/Empfangen von magnetischen Signalen. Die Sende-/Empfangsanordnung weist einen Mikrocontroller und einen elektromagnetischen Schwingkreis [z. B. mit einer Spule und einem Kondensator] auf, wobei der Mikrocontroller mit dem elektromagnetischen Schwingkreis [z. B. direkt] verbunden ist, wobei der Mikrocontroller konfiguriert ist, um, in einem Sendemodus,

- den elektromagnetischen Schwingkreis in Serienresonanz zu betreiben, und

- ein erstes Signal zum Ansteuern des [z. B. in Serienresonanz betriebenen] elektromagnetischen Schwingkreis zu generieren und den elektromagnetischen Schwingkreis mit dem generierten ersten Signal anzusteuern, um mit dem elektromagnetischen Schwingkreis ein erstes magnetisches Signal [z. B. magnetisches Feld] zu erzeugen, das erste Daten trägt,

wobei der Mikrocontroller konfiguriert ist, um, in einem Empfangsmodus,

- den [z. B. selben] elektromagnetischen Schwingkreis in Serienresonanz zu betreiben, und

- ein von dem [z. B. in Serienresonanz betriebenen] elektromagnetischen Schwingkreis bereitgestelltes zweites Signal auszuwerten, das von einem von dem elektromagnetischen Schwingkreis detektierten zweiten magnetischen Signal [z. B. magnetischen Feld] abhängig ist, um zweite Daten zu empfangen.

Bei Ausführungsbeispielen weist der elektromagnetische Schwingkreis eine Spule und einen Kondensator auf, die in Reihe geschaltet sind zwischen einem ersten Knoten und einem zweiten Knoten, wobei in einem Sendemodus

- ein erstes Bezugspotential [z. B. Masse] an dem zweiten Knoten angelegt ist [z. B. wobei der Mikrocontroller konfiguriert ist, um das erste Bezugspotential an dem Knoten anzulegen] und

- der Mikrocontroller konfiguriert ist, um ein erstes Signal zum Ansteuern des elektromagnetischen Schwingkreis zu generieren und das generierte erste Signal über den ersten Knoten auf den elektromagnetischen Schwingkreis [z. B. niederohmig] aufzuprägen, um mit dem elektromagnetischen Schwingkreis ein erstes magnetisches Signal [z. B. magnetisches Feld] zu erzeugen, das erste Daten trägt,

wobei in einem Empfangsmodus,

- ein zweites Bezugspotential [z. B. Masse] an dem ersten oder zweiten Knoten angelegt ist [z. B. wobei der Mikrocontroller konfiguriert ist, um das zweite Bezugspotential an dem Knoten anzulegen], und

- ein von dem elektromagnetischen Schwingkreis bereitgestelltes zweites Signal, das von einem von dem elektromagnetischen Schwingkreis empfangen zweiten magnetischen Signal [z. B. magnetischen Feld] abhängig ist, über den ersten oder zweiten Knoten [z. B. niederohmig] abzugreifen, um zweite Daten zu erhalten.

Weitere Ausführungsbeispiele schaffen eine Sende-/Empfangsanordnung zum Senden/Empfangen von magnetischen Signalen. Die Sende-/Empfangsanordnung weist einen Mikrocontroller und einen elektromagnetischen Schwingkreis [z. B. mit einer Spule und einem Kondensator] auf, wobei der Mikrocontroller mit dem elektromagnetischen Schwingkreis [z. B. direkt] verbunden ist, wobei der Mikrocontroller konfiguriert ist, um, in einem Sendemodus,

- den elektromagnetischen Schwingkreis in Serienresonanz zu betreiben, und
- ein erstes Signal zum Ansteuern des [z. B. in Serienresonanz betriebenen] elektromagnetischen Schwingkreis zu generieren und den elektromagnetischen Schwingkreis mit dem generierten ersten Signal anzusteuern, um mit dem elektromagnetischen Schwingkreis ein erstes magnetisches Signal [z. B. magnetisches Feld] zu erzeugen, das erste Daten trägt,

wobei der Mikrocontroller konfiguriert ist, um, in einem Empfangsmodus,

- den [z. B. selben] elektromagnetischen Schwingkreis in Serienresonanz zu betreiben, und
- ein von dem [z. B. in Serienresonanz betriebenen] elektromagnetischen Schwingkreis bereitgestelltes zweites Signal auszuwerten, das von einem von dem elektromagnetischen Schwingkreis detektierten zweiten magnetischen Signal [z. B. magnetischen Feld] abhängig ist, um zweite Daten zu empfangen.

Bei Ausführungsbeispielen ist der Mikrocontroller mit dem elektromagnetischen Schwingkreis [z. B. mit dem ersten Knoten] über eine Umkonfigurierschaltung verbunden, wobei der Mikrocontroller konfiguriert ist, um, in einem Sendemodus,

- [z. B. die Umkonfigurierschaltung zu deaktivieren, und]
- ein erstes Signal zum Ansteuern des elektromagnetischen Schwingkreis zu generieren und den elektromagnetischen Schwingkreis mit dem generierten ersten Signal anzusteuern, um mit dem elektromagnetischen Schwingkreis ein erstes magnetisches Signal [z. B. magnetisches Feld] zu erzeugen, das erste Daten trägt,

wobei der Mikrocontroller konfiguriert ist, um, in einem Empfangsmodus,

- [z. B. die Umkonfigurierschaltung zu aktivieren, und]

- ein von dem elektromagnetischen Schwingkreis bereitgestelltes zweites Signal, das von einem von dem elektromagnetischen Schwingkreis empfangen zweiten magnetischen Signal [z. B. magnetischen Feld] abhängig ist, über die Umkonfigurierschaltung zu erfassen, um zweite Daten zu erhalten,

wobei die Umkonfigurierschaltung ausgebildet ist, um einen Strom in eine [z. B. proportionale] Ausgangsspannung [z. B. entsprechend einer streng monotonen Funktion] umzuwandeln.

Bei Ausführungsbeispielen bedeutet niederohmig weniger als das doppelte oder fünffache des resistiven Widerstands der Spule des elektromagnetischen Schwingkreises.

Bei Ausführungsbeispielen ist die Umkonfigurierschaltung ein Strom-Spannungs-Wandler oder ein niederohmiger Verstärker.

Bei Ausführungsbeispielen ist der niederohmiger Verstärker ein Transimpedanzverstärker oder ein als Transimpedanzverstärker verschalteter Operationsverstärker.

Bei Ausführungsbeispielen weist der elektromagnetische Schwingkreis eine Spule und einen Kondensator auf, die in Reihe geschaltet sind zwischen einem ersten Knoten und einem zweiten Knoten, wobei die Spule und der Kondensator über einen dritten Knoten miteinander verbunden sind.

Bei Ausführungsbeispielen ist der Mikrocontroller konfiguriert, um, in dem Sendemodus, an dem ersten Knoten das erste Signal anzulegen.

Bei Ausführungsbeispielen ist der Mikrocontroller konfiguriert, um, in dem Sendemodus, an dem zweiten Knoten ein Bezugspotential oder ein zu dem ersten Signal komplementäres Signal anzulegen.

Bei Ausführungsbeispielen ist der Mikrocontroller konfiguriert, um, in dem Empfangsmodus, an dem zweiten Konten ein Bezugspotential anzulegen.

Bei Ausführungsbeispielen ist ein erster Anschluss [z. B. erster Pin] des Mikrocontrollers mit dem ersten Knoten verbunden, wobei ein zweiter Anschluss [z. B. zweiter Pin] des Mikrocontrollers über den als Transimpedanzverstärker verschalteten Operationsverstärker mit dem ersten Knoten verbunden ist.

Bei Ausführungsbeispielen ist der zweite Knoten mit einem dritten Anschluss [z. B. dritter Pin] des Mikrocontrollers oder einem Bezugspotentialanschluss [z. B. Masseanschluss] verbunden.

Bei Ausführungsbeispielen weist der elektromagnetische Schwingkreis ferner einen Abstimmkondensator auf, der zwischen dem dritten Knoten und einem vierten Anschluss [z. B. vierten Pin] des Mikrocontrollers geschaltet ist, obei der Mikrocontroller konfiguriert ist, um den elektromagnetischen Schwingkreis durch Schalten des vierten Anschlusses auf einen von zumindest zwei unterschiedlichen Betriebsmodi [z. B. in dem ein definiertes Bezugspotential bereitgestellt wird, in dem ein zum ersten Signal komplementäres Signal bereitgestellt wird, in dem der vierte Anschluss auf einen hochohmig Zustand geschaltet wird] abzustimmen.

Bei Ausführungsbeispielen kann ein erster Eingang des Operationsverstärkers mit dem ersten Knoten verbunden sein.

Bei Ausführungsbeispielen kann ein zweiter Eingang des Operationsverstärkers über einen Überbrückungskondensator mit einem Bezugspotentialanschluss [z. B. Masseanschluss] verbunden sein.

Bei Ausführungsbeispielen kann ein Ausgang des Operationsverstärkers mit dem zweiten Anschluss des Mikrocontrollers verbunden sein.

Bei Ausführungsbeispielen kann ein erster Wiederstand in Reihe geschaltet sein zwischen dem ersten Knoten und dem zweiten Anschluss des Mikrocontrollers.

Bei Ausführungsbeispielen kann eine erste Diode in Durchlassrichtung geschaltet sein zwischen dem ersten Knoten und dem zweiten Anschluss des Mikrocontrollers.

Bei Ausführungsbeispielen kann eine zweite Diode in Sperrrichtung geschaltet sein zwischen dem ersten Knoten und dem zweiten Anschluss des Mikrocontrollers.

Bei Ausführungsbeispielen kann ein erster Versorgungsanschluss des Operationsverstärkers mit einem Versorgungsspannungsanschluss verbunden sein.

Bei Ausführungsbeispielen kann ein zweiter Versorgungsanschluss des Operationsverstärkers mit einem Bezugspotentialanschluss [z. B. Masseanschluss] verbunden sein.

Bei Ausführungsbeispielen kann der erste Versorgungsanschluss über zwei in Reihe geschaltete Wiederstände mit dem Bezugspotentialanschluss [z. B. Masseanschluss] verbunden sein.

Bei Ausführungsbeispielen kann ein Knoten zwischen den zwei in Reihe geschalteten Wiederständen mit dem zweiten Eingang des Operationsverstärkers verbunden sein.

Bei Ausführungsbeispielen kann der zweite Anschluss des Mikrocontrollers mit einem fünften Anschluss des Mikrocontrollers über einen vierten Wiederstand verbunden sein.

Bei Ausführungsbeispielen kann der fünfte Anschluss des Mikrocontrollers über einen zweiten Kondensator mit einem Bezugspotentialanschluss [z. B. Masseanschluss] verbunden sein.

Bei Ausführungsbeispielen ist der Operationsverstärker konfiguriert, um, in dem Empfangsmodus, eine an dem Ausgang bereitgestellt Spannung $U_{Ausgang}$ basierend auf der folgenden Formel zu regeln:

$$U_{Ausgang} = -I_L \cdot R1 + U_{Eingang\,2}$$

wobei $I_L$ der durch die Spule des elektromagnetischen Schwingkreises fließende Strom ist, wobei R1 der Widerstandswert des ersten Wiederstands ist, und wobei $U_{Eingang\,2}$ eine an dem zweiten Eingang des Operationsverstärkers anliegende Spannung ist.

Bei Ausführungsbeispielen sind der zweite Anschluss und der fünfte Anschluss des Mikrocontrollers Komparatoreingänge.

Bei Ausführungsbeispielen ist der erste Anschluss des Mikrocontrollers [z. B. direkt] mit dem ersten Knoten verbunden.

Bei Ausführungsbeispielen ist der erste Anschluss des Mikrocontrollers über eine Verstärkerschaltung mit dem ersten Knoten verbunden.

Bei Ausführungsbeispielen weist die Verstärkerschaltung einen ersten elektronischen Schalter und einen zweiten elektronischen Schalter auf, die in Reihe geschaltet sind zwischen einem Versorgungsspannungsanschluss und einem Bezugspotentialanschluss, wobei ein Ausgangsanschluss der Verstärkerschaltung zwischen dem ersten elektronischen Schalter und den zweiten elektronischen Schalter mit dem ersten Knoten verbunden ist, wobei der Mikrocontroller konfiguriert ist, um, in dem Sendemodus, über die Verstärkerschaltung ein pulsweitenmoduliertes erstes Signal an dem ersten Knoten anzulegen.

Weitere Ausführungsbeispiele schaffen ein Gerät mit einer Konfigurations- und/oder Bedienschnittstelle zum Konfigurieren und/oder Bedienen des Geräts, wobei die Konfigurations- und/oder Bedienschnittstelle eine Sende-/Empfangsanordnung gem. einem der hierin beschriebenen Ausführungsbeispielen aufweist.

Ausführungsbeispiele der vorliegenden Erfindung werden bezugnehmend auf die beiliegenden Figuren näher beschrieben. Es zeigen:

Fig. 1 ein schematisches Blockschaltbild eines Systems mit einem Benutzerendgerät und einem anderen Gerät, gemäß einer ersten beispielhaften Ausgestaltung;

Fig. 2a ein schematisches Blockschaltbild eines Systems mit einem Benutzerendgerät und einem anderen Gerät, gemäß einer zweiten beispielhaften Ausgestaltung;

Fig. 2b ein schematisches Blockschaltbild eines Systems mit einem Benutzerendgerät und einem anderen Gerät, gemäß einer dritten beispielhaften Ausgestaltung;

Fig. 2c ein schematisches Blockschaltbild eines Systems mit einem Benutzerendgerät und einem anderen Gerät, gemäß einer vierten beispielhaften Ausgestaltung;

Fig. 3 ein schematisches Blockschaltbild eines Systems mit einem Benutzerendgerät und einem anderen Gerät, gemäß einer fünften beispielhaften Ausgestaltung;

Fig. 4    ein schematisches Blockschaltbild einer Sende-/Empfangsanordnung zum Senden/Empfangen von magnetischen Signalen, gemäß einem Ausführungsbeispiel der vorliegenden Erfindung;

Fig. 5    ein schematisches Blockschaltbild einer Sende-/Empfangsanordnung zum Senden/Empfangen von magnetischen Signalen, gemäß einem weiteren Ausführungsbeispiel der vorliegenden Erfindung;

Fig. 6    ein schematisches Blockschaltbild einer Sende-/Empfangsanordnung zum Senden/Empfangen von magnetischen Signalen, gemäß einem weiteren Ausführungsbeispiel der vorliegenden Erfindung;

Fig. 7    in einem Diagramm Übertragungsfunktionen verschiedener Kombinationen von Schwingkreisen;

Fig. 8    ein schematisches Blockschaltbild einer Sende-/Empfangsanordnung zum Senden/Empfangen von magnetischen Signalen, gemäß einem weiteren Ausführungsbeispiel der vorliegenden Erfindung;

Fig. 9    ein schematisches Blockschaltbild einer Sende-/Empfangsanordnung zum Senden/Empfangen von magnetischen Signalen, gemäß einem weiteren Ausführungsbeispiel der vorliegenden Erfindung; und

Fig. 10    ein schematisches Blockschaltbild einer beispielhaften Implementierung der in Fig. 9 gezeigten Sende-/Empfangsanordnung, gemäß einem Ausführungsbeispiel der vorliegenden Erfindung.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

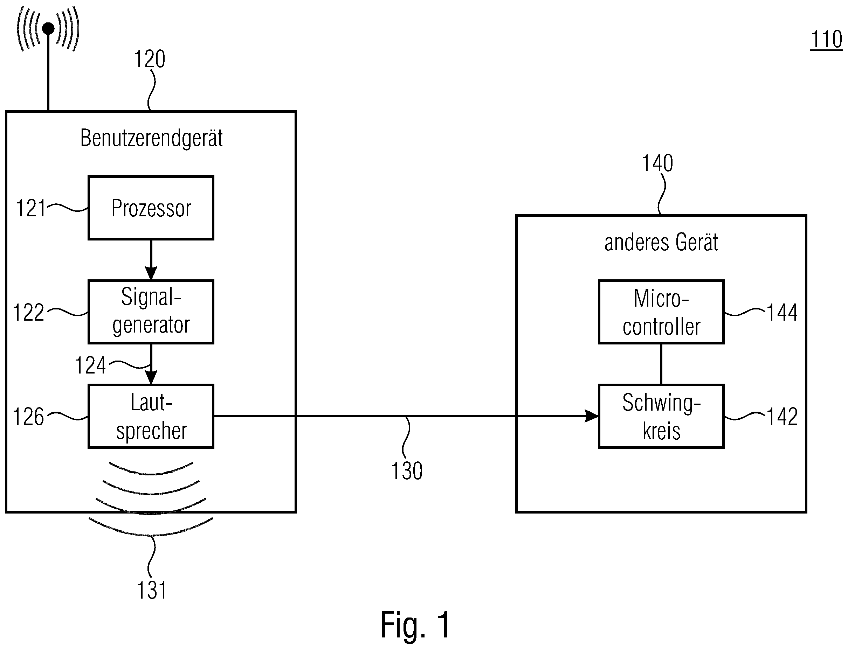

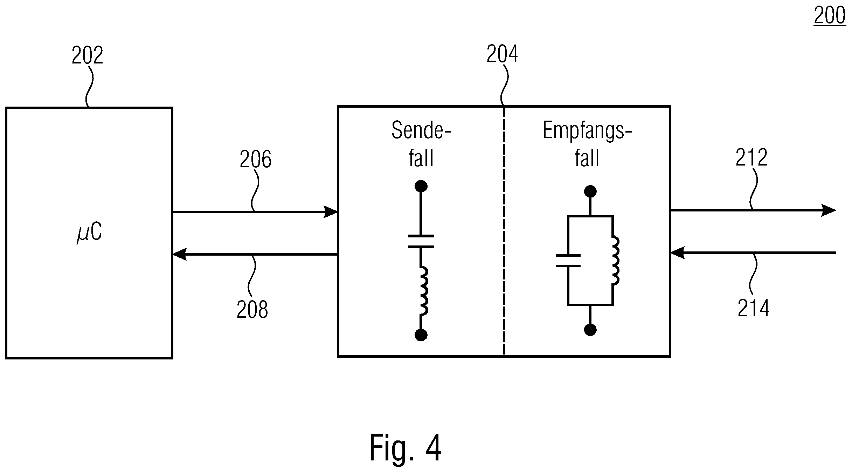

Bevor jedoch Ausführungsbeispiele der vorliegenden Erfindung anhand der Fig. 4 bis 10 näher beschrieben werden, wird zunächst anhand der Fig. 1 bis 3 ein beispielhaftes Kommunikationssystem beschrieben, in der die erfindungsgemäße Sende-/Empfangsanordnung Anwendung finden kann. Ausführungsbeispiele sind jedoch nicht auf solche Anwendungen beschränkt, vielmehr kann die erfindungsgemäße Sende-/Empfangsanordnung auch in anderen Kommunikationssystemen Anwendung finden, insbesondere wenn Daten über kürzere Distanzen (z. B. bis zu 1 m) übertragen werden sollen.

Fig. 1 zeigt ein schematisches Blockschaltbild eines Systems 110 mit einem Benutzerendgerät 120 und einem anderen Gerät 140, gemäß einer ersten beispielhaften Ausgestaltung.

Das Benutzerendgerät 120 umfasst einen Prozessor 121, einen Signalgenerator 122 und einen Lautsprecher 126 mit einem elektromagnetischen Aktuator (z. B. einer Schwingspule). Das Benutzerendgerät 120 (oder z. B. der Prozessor 121 des Benutzerendgeräts 120) ist ausgebildet, um den Signalgenerator 122 anzusteuern ein Signal 124 zum Ansteuern des Lautsprechers 126 zu generieren und den Lautsprecher 126 mit dem generierten Signal 124 anzusteuern, um durch den Lautsprecher 126 bzw. den elektromagnetischen Aktuator des Lautsprechers 126 ein magnetisches Signal/Feld 130 zu erzeugen, das von dem Benutzerendgerät 120 zu dem anderen Gerät 140 zu übertragene Daten trägt.

Das generierte Signal 124 kann im Ultraschallfrequenzbereich oder höher liegen. Die durch das Ansteuern des Lautsprechers 126 mit dem generierten Signal 124 ebenfalls erzeugten Schallwellen 131 liegen somit einem für den Menschen nicht oder nur schlechter hörbaren Frequenzbereich oder werden bedingt durch die obere Grenzfrequenz des Lautsprechers 126 im Idealfall (z. B. keine Nichtlinearitäten) nicht oder nur gedämpft abgestrahlt. Beispielsweise kann eine Frequenz oder ein Frequenzbereich des generierten Signals 126 oberhalb von 16 kHz liegen, z. B. im Bereich zwischen 16 kHz und 22 kHz.

Die Daten können dem generierten Signal 128 aufmoduliert sein, beispielsweise durch FSK (FSK = frequency shift keying, d.t. Frequenzumtastung), MSK (MSK = minimum shift keying) oder GMSK (GMSK = gaussian minimum shift keying). Natürlich kann auch eine andere Modulationsart zum Einsatz kommen, wie z. B. ASK (ASK = amplitude shift keying, dt. Amplitudenumtastung), oder PSK (PSK = phase shift keying, dt. PHasenumtastung) oder OOK (OOK = on-off keying, dt. eine Art der Amplitudenumtastung, bei der der Träger an- und ausgeschaltet wird).

Ein Verhältnis zwischen Trägerfrequenz und Modulationsbandbreite des generierten Signals 124 kann kleiner sein als 25% (oder beispielsweise kleiner als 20% oder kleiner als 15%).

Das Benutzerendgerät 120 kann ein Mobiltelefon (Smartphone) oder Tablet sein.

Wie in Fig. 1 zu erkennen ist, umfasst das andere Gerät 140 einen elektromagnetischen Schwingkreis 142, der ausgebildet ist, um das magnetische Feld 130, das die Daten trägt, zu detektieren. Ferner umfasst das andere Gerät 140 einen Mikrocontroller 144, der ausgebildet ist, um das detektierte magnetische Feld 130 auszuwerten, um die Daten zu empfangen.

Die Daten, die das Magnetfeld 130 trägt, können beispielsweise Konfigurationsdaten oder Bediendaten sein. Der Mikrocontroller 144 kann ausgebildet sein, um basierend auf den Bediendaten eine Bedienoperation auszuführen bzw. das andere Gerät 140 basierend auf den Konfigurationsdaten zu konfigurieren, z. B. in ein drahtloses Netzwerk einzubinden.

Das andere Gerät 140 kann beispielsweise ein benutzerkonfigurierbares Gerät sein, wie z. B. ein IoT-Knoten (IoT = internet of things, dt. Internet der Dinge) (z. B. ein Sensorknoten oder Aktorknoten) oder eine WLAN Kamera. In diesem Fall können die Konfigurationsdaten eine Information zur Einbindung des benutzerkonfigurierbaren Geräts 140 in ein drahtloses Netzwerk (z. B. Sensornetzwerk oder WLAN) aufweisen, wie z. B. ein Netzwerkname und Netzwerkschlüssel. Natürlich können dem benutzerkonfigurierbaren Gerät 140 durch die Konfigurationsdaten auch andere Parameter zugewiesen werden, wie z. B. einen zu verwenden Frequenzkanal, zu verwendenden Zeitschlitze, oder ein zu verwendendes Sprungmuster (engl. hopping pattern).

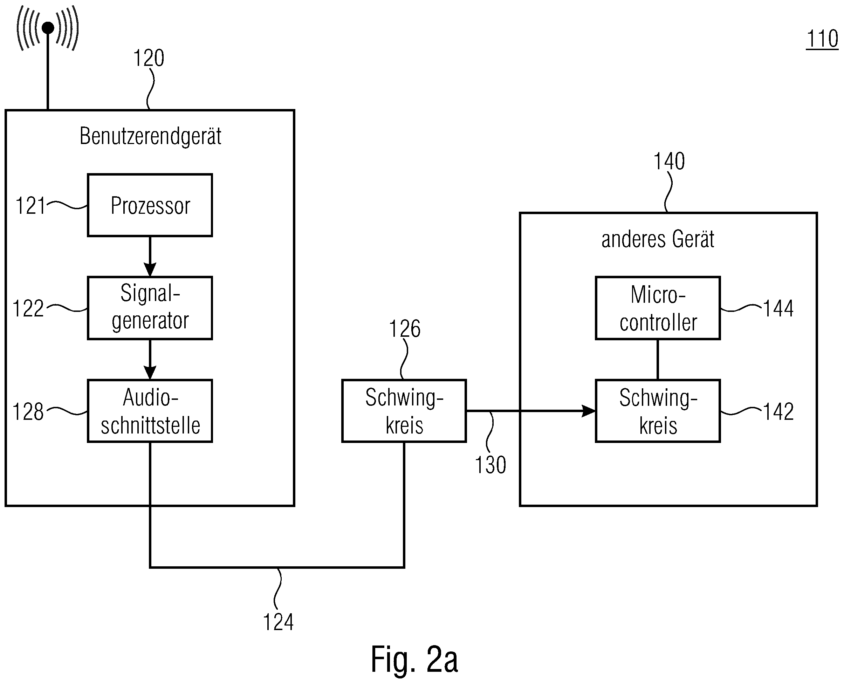

Anstelle eines Lautsprechers kann auch ein mit dem Benutzerendgerät 120 verbundener elektromagnetischer Schwingkreis verwendet werden, um das elektromagnetische Signal/Feld 130 zu erzeugen, das die ersten Daten trägt, wie dies nachfolgend anhand er Fig. 2a-2c erläutert wird.

Fig. 2a zeigt ein schematisches Blockschaltbild eines Systems 110 mit einem Benutzerendgerät 120 und einem anderen Gerät 140, gemäß einer zweiten beispielhaften Ausgestaltung.

Das Benutzerendgerät 120 umfasst einen Signalgenerator 122, wobei das Benutzerendgerät 120 (oder z. B. ein Prozessor 121 des Benutzerendgeräts 120) ausgebildet ist, um den Signalgenerator 122 anzusteuern ein Signal 124 zum Ansteuern eines elektromagnetischen Schwingkreises 126 zu generieren und den elektromagnetischen Schwingkreises 126 mit dem generierten Signal 124 anzusteuern, um durch den elektromagnetischen Schwingkreis 126 ein erstes magnetisches Feld 130 zu erzeugen, das von dem Benutzerendgerät 120 zu dem anderen Gerät 140 zu übertragene erste Daten trägt.

Der Signalgenerator 122 kann ein Audiosignalgenerator sein. Herkömmlicherweise ist ein solcher Audiosignalgenerator 122 ausgebildet, um ein Audiosignal zur Ansteuerung eines mit dem Benutzerendgerät 120 verbundenen Audiowiedergabegeräts (z. B. Kopfhörer) zu generieren, wobei gem. Fig. 2a anstelle eines Audiowiedergabegeräts der elektromagnetische Schwingkreis 126 mit dem vom Audiosignalgenerators 122 generierten Signal 124 angesteuert wird, um das magnetische Feld 130 zu generieren, das die Daten trägt. Beispielsweise kann der Audiosignalgenerator 122 ein Verstärker sein.

Der elektromagnetische Schwingkreis 126 kann über eine Audioschnittstelle 128 mit dem Signalgenerator 122 verbunden sein. Beispielsweise kann die Audioschnittstelle 128 eine kabelgebundene Audioschnittstelle sein, wie z. B. eine Klinkenbuchse, ein USB-C®-Audio Anschluss oder ein Lightning®-Audio Anschluss.

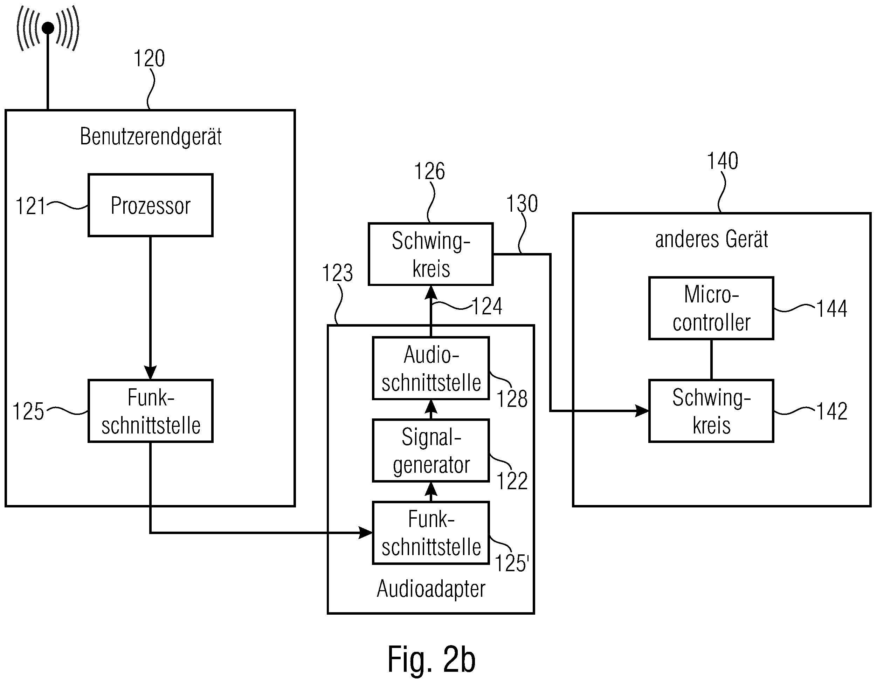

Bei dem in Fig. 2a gezeigtem Beispiel weist das Benutzerendgerät 120 den Signalgenerator 122 auf. Alternativ kann der Signalgenerator 122 auch extern zu dem Benutzerendgerät 120 ausgeführt sein. Beispielsweise kann der Signalgenerator 122 in einem mit dem Benutzerendgerät 120 verbundenen drahtlosen Audioadapter implementiert sein, wie dies in Fig. 2b gezeigt ist.

Im Detail zeigt Fig. 2b ein schematisches Blockschaltbild eines Systems 110 mit einem Benutzerendgerät 120 und einem anderen Gerät 140, wobei das Benutzerendgerät 120 drahtlos (z. B. über entsprechende Funkschnittstellen 125, 125' (z. B. Bluetooth, WLAN, Certified Wireless USB)) mit einem drahtlosen Audioadapter 123 verbunden ist, der den Signalgenerator 122 aufweist.

Wie in Fig. 2b zu erkennen ist, kann in diesem Fall der elektromagnetische Schwingkreis 126 über eine Audioschnittstelle 128 des drahtlosen Audioadapters 123 mit dem Signalgenerator 122 verbunden sein. Die Audioschnittstelle 128 kann eine kabelgebundene Audioschnittstelle sein, wie z. B. eine Klinkenbuchse, ein USB-C®-Audio Anschluss oder ein Lightning®-Audio Anschluss.

Der drahtlose Audioadapter 123 kann beispielsweise ein Bluetooth, WLAN oder Certified Wireless USB Audioadapter sein.

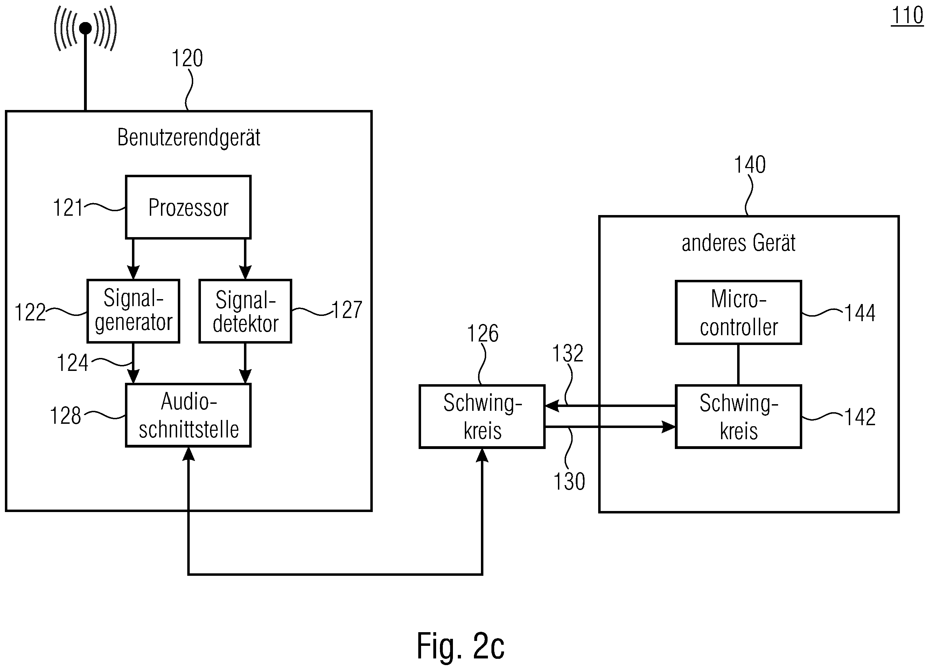

Die in den Fig. 2a und 2b gezeigte Anordnung kann auch zur bidirektionalen Übertragung von Daten zwischen dem Benutzerendgerät 120 und dem anderen Gerät 140 genutzt werden, wie dies nachfolgend anhand von Fig. 2c erläutert wird.

Im Detail zeigt Fig. 2c ein schematisches Blockschaltbild eines Systems 110 mit einem Benutzerendgerät 120 und einem anderen Gerät 140, gemäß einer vierten beispielhaften Ausgestaltung.

Das Benutzerendgerät 122 (oder der Prozessor 121 des Benutzerendgeräts 122) kann ausgebildet sein, um mittels des Signalgenerators 122 ein Signal 124 zum Ansteuern des mit dem Benutzerendgerät 120 verbundenen elektromagnetischen Schwingkreises 126 zu generieren, und um den elektromagnetischen Schwingkreises 126 mit dem generierten Signal 124 anzusteuern, um durch den elektromagnetischen Schwingkreis 126 ein erstes magnetisches Feld 130 zu erzeugen, das von dem Benutzerendgerät 120 zu dem anderen Gerät 140 zu übertragene erste Daten trägt.

Ferner kann das Benutzerendgerät 122 (oder der Prozessor 121 des Benutzerendgeräts 122) ausgebildet sein, um mittels eines Signaldetektors 127 ein von dem elektromagnetischen Schwingkreis 126 ansprechend auf das zweite magnetische Feld 132 bereitgestelltes Signal zu detektieren, um von dem anderen Gerät 140 zu dem Benutzerendgerät 120 zu übertragene zweite Daten zu empfangen, die das zweite magnetische Feld 130 trägt.

Das Benutzerendgerät 122 kann ferner ausgebildet sein, um das detektiere Signal auszuwerten, um die zweiten Daten zu empfangen.

Das Benutzerendgerät 122 kann sowohl den Signalgenerator 122 als auch den Signaldetektor 127 aufweisen. Der elektromagnetische Schwingkreis 126 kann dabei mit dem Signalgenerator 122 und dem Signaldetektor 127 über die bidirektionale Audioschnittstelle 128 (z. B. Audioausgang und Audioeingang (Mikrofoneingang)) verbunden sein. Die bidirektionale Audioschnittstelle 128 kann eine kabelgebundene Audioschnittstelle sein, wie z. B. eine Klinkenbuchse, ein USB-C®-Audio Anschluss oder ein Lightning®-Audio Anschluss.

Natürlich ist es genauso möglich, dass analog zu Fig. 2b sowohl der Signalgenerator 122 als auch der Signaldetektor 127 extern zu dem Benutzerendgerät 120 ausgeführt sind. So kann der drahtlose Audioadapter (siehe Fig. 2b) den Signalgenerator 122 und den Signaldetektor 127 aufweisen, wobei der elektromagnetische Schwingkreis 126 in diesem Fall über die bidirektionale Audioschnittstelle des drahtlosen Audioadapters mit dem Signalgenerator 122 und dem Signaldetektor 127 verbunden ist. Die bidirektionale Audioschnittstelle 128 kann eine kabelgebundene Audioschnittstelle sein, wie z. B. eine Klinkenbuchse, ein USB-C®-Audio Anschluss oder ein Lightning®-Audio Anschluss.

Der Mikrocontroller 144 des anderen Geräts 140 kann ausgebildet sein, um mit dem elektromagnetischen Schwingkreis 142 des anderen Geräts 140 das zweite magnetisches Feld 132 zu erzeugen, das die von dem anderen Gerät 140 zu dem Benutzerendgerät 120 zu übertragene zweite Daten trägt.

Beispielsweise kann der Mikrocontroller 144 des anderen Geräts 140 ausgebildet sein, um ein Signal zum Ansteuern des elektromagnetischen Schwingkreises 142 des anderen Geräts 140 zu generieren, und um den elektromagnetischen Schwingkreis 142 des anderen Geräts 140 mit dem generierten Signal anzusteuern, um durch den elektromagnetischen Schwingkreis 142 des anderen Geräts 140 das zweite magnetisches Feld 132 zu erzeugen, das die zweiten Daten trägt.

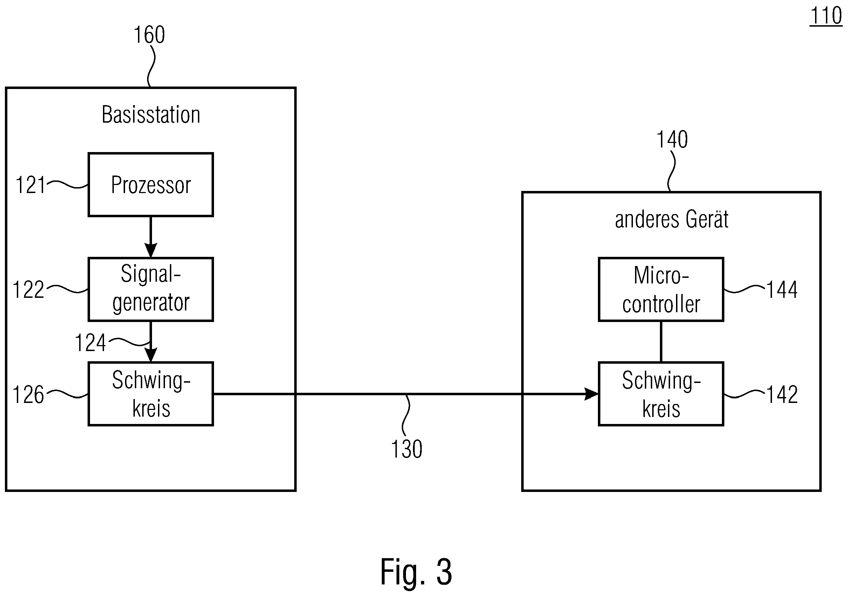

Natürlich ist es genauso möglich, den elektromagnetischen Schwingkreis 126 direkt in das Benutzerendgerät zu integrieren, wie dies in Fig. 3 gezeigt ist.

Im Detail zeigt Fig. 3 ein schematisches Blockschaltbild eines Systems 110 mit einem Benutzerendgerät 120 und einem anderen Gerät 140, gemäß einer fünften beispielhaften Ausgestaltung.

Das Benutzerendgerät 122 umfasst einen Prozessor 121, einen Signalgenerator 122 und einen elektromagnetischen Schwingkreis 126. Das Benutzerendgerät 122 (oder der Prozessor 121 des Benutzerendgeräts 122) kann ausgebildet sein, um mittels des Signalgenerators 122 ein Signal 124 zum Ansteuern des elektromagnetischen Schwingkreises 126 zu generieren, und um den elektromagnetischen Schwingkreises 126 mit dem generierten Signal 124 anzusteuern, um durch den elektromagnetischen Schwingkreis 126 ein erstes magnetisches Feld 130 zu erzeugen, das von dem Benutzerendgerät 120 zu dem anderen Gerät 140 zu übertragene erste Daten trägt.

Natürlich kann das in Fig. 3 gezeigte Beispiel ebenfalls um eine bidirektionale Kommunikationsschnittstelle erweitert werden. Hierzu kann beispielsweise der aus Fig. 2c bekannte Signaldetektor 127 zwischen Prozessor 121 und elektromagnetischem Schwingkreis geschaltet werden, z. B. um ein von dem elektromagnetischen Schwingkreis 126 ansprechend auf das zweite magnetische Feld bereitgestelltes Signal zu detektieren, um von dem anderen Gerät 140 zu dem Benutzerendgerät 120 zu übertragene zweite Daten zu empfangen, die das zweite magnetische Feld trägt.

Wie im Folgenden ausgeführt wird ist die Reichweite und/oder Datenrate bei dem in den Fig. 1 bis 3 gezeigten Kommunikationssystem begrenzt.

Die im folgenden beschrieben Sende-/Empfangsanordnung mit einem Mikrocontroller und einem elektromagnetischen Schwingkreis gemäß Ausführungsbeispielen der vorliegenden Erfindung ermöglicht es die Reichweite und/oder Datenrate durch eine optimierte Verschaltung des elektromagnetischen Schwingkreises zu erhöhen.

Die Sende-/Empfangsanordnung kann hierbei in dem oben beschriebenen Kommunikationssystem Anwendung finden, beispielsweise in dem anderen Gerät 140 aber auch in dem Benutzerendgerät 120 z. B. als Ersatz einer herkömmliche RFID Schnittstelle. Natürlich kann die Sende-/Empfangsanordnung aber auch in anderen Kommunikationssystemen Anwendung finden, wie z. B. zum Abfragen von Status- und/oder Fehlerinformationen von Geräten.

1. Konfiguration eines Schwingkreises in Serienresonanz zum Senden und desselben in Parallelresonanz zum Empfangen von Daten

Bei dem in den Fig. 1 bis 3 gezeigten Kommunikationssystem wird ein elektromagnetischer Schwingkreis zur Erzeugung des elektromagnetischen Signals verwendet. Dieser Schwingkreis besteht typischerweise aus einer Spule (Induktivität) und einem Kondensator (Kapazität), welche sowohl zum Senden als auch zum Empfangen von Daten in Parallelresonanz arbeiten. Beim Senden mittels Parallelresonanz ist der durch die Spule fließende Strom jedoch durch die an ihr anliegende Spannung und damit durch die Ausgangsspannung des signalerzeugenden Bauteils begrenzt. Der durch die Spule fließende Strom definiert die Stärke des erzeugten Magnetfelds und damit auch die Reichweite des Kommunikationssystems.

Ausführungsbeispiele der vorliegenden Erfindung schaffen daher eine Sende-/Empfangsanordnung, die zum Senden ein Reihenschwingkreis und zum Empfangen ein Parallelschwingkreis verwendet. Durch die Verwendung eines Reihenschwingkreis zum Senden erhöht sich die an der Spule anliegenden Spannung über die Ausgangsspannung des signalerzeugenden Bauteils. Damit steigt der durch die Spule fließende Strom, die Stärke des Magnetfelds und letztendlich die Reichweite des Kommunikationssystems.

Fig. 4 zeigt ein schematisches Blockschaltbild einer Sende-/Empfangsanordnung 200 zum Senden/Empfangen von magnetischen Signalen, gemäß einem Ausführungsbeispiel der vorliegenden Erfindung.

Die Sende-/Empfangsanordnung 200 umfasst einen Mikrocontroller 202 und einen elektromagnetischen Schwingkreis 204, beispielsweise mit einer Spule und einem Kondensator, wie dies in Fig. 4 angedeutet ist, wobei der Mikrocontroller 202 mit dem elektromagnetischen Schwingkreis 204 verbunden ist.

Der Mikrocontroller 202 ist hierbei konfiguriert, um, in einem Sendemodus,

- den elektromagnetischen Schwingkreis 204 in Serienresonanz zu betreiben, und
- ein erstes Signal 206 zum Ansteuern des elektromagnetischen Schwingkreis 204 zu generieren und den elektromagnetischen Schwingkreis 204 mit dem generierten ersten Signal 206 anzusteuern, um mit dem elektromagnetischen Schwingkreis 204 ein erstes magnetisches Signal 212 zu erzeugen, das erste Daten trägt.

Ferner ist der Mikrocontroller 202 konfiguriert, um, in einem Empfangsmodus,

- den elektromagnetischen Schwingkreis 204 in Parallelresonanz zu betreiben, und
- ein von dem elektromagnetischen Schwingkreis 204 bereitgestelltes zweites Signal 208 auszuwerten, das von einem von dem elektromagnetischen Schwingkreis 204 detektierten zweiten magnetischen Signal 214 abhängig ist, um zweite Daten zu empfangen.

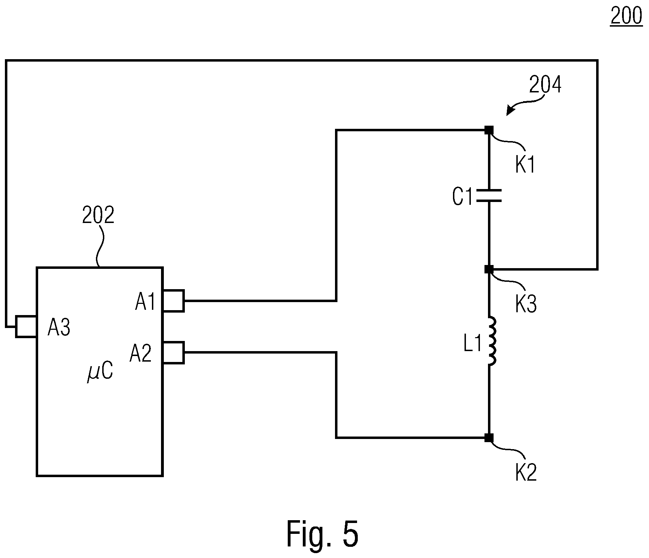

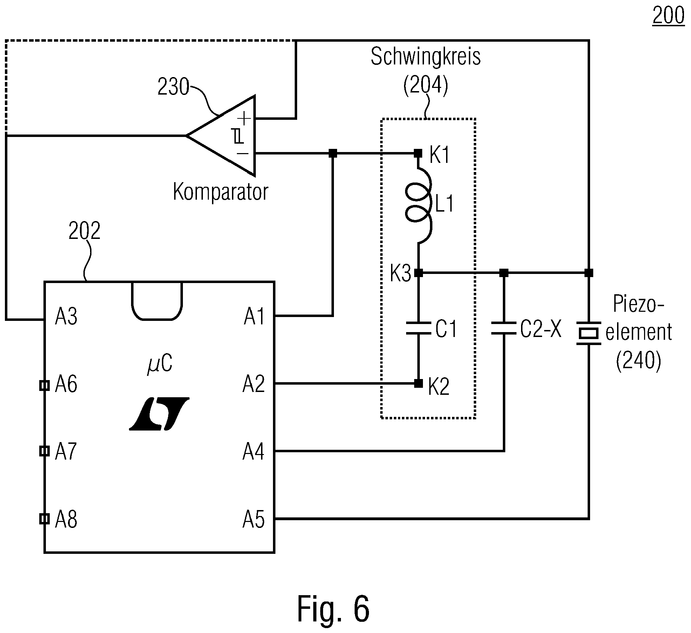

Detaillierte Ausführungsbeispiele der in Fig. 4 gezeigten Sende-/Empfangsanordnung 200 werden nachfolgend anhand der Fig. 5 und 6 näher erläutert.

Fig. 5 zeigt ein schematisches Blockschaltbild einer Sende-/Empfangsanordnung 200 zum Senden/Empfangen von magnetischen Signalen, gemäß einem weiteren Ausführungsbeispiel der vorliegenden Erfindung.

Wie in Fig. 5 zu erkennen ist, kann der elektromagnetische Schwingkreis 204 eine Spule L1 und einen Kondensator C1 aufweisen, die in Reihe geschaltet sind zwischen einem ersten Knoten K1 und einem zweiten Knoten K2, wobei die Spule L1 und der Kondensator C1 über einen dritten Knoten K3 miteinander verbunden sind.

Bei dem in Fig. 5 gezeigten Ausführungsbeispiel wird beispielhaft davon ausgegangen, dass der Kondensator C1 zwischen dem ersten Knoten K1 und dem dritten Knoten K3 geschaltet ist, während die Spule L1 zwischen dem dritten Knoten K3 und dem zweiten Knoten K2 geschaltet ist. Bei Ausführungsbeispielen können der Kondensator C1 und die Spule L1 jedoch genauso andersherum in Reihe zwischen dem ersten Knoten K1 und dem zweiten Knoten K2 geschaltet sein, d.h. die Spule L1 kann zwischen dem ersten Knoten K1 und dem dritten Knoten K3 geschaltet sein, während der Kondensator C1 zwischen dem dritten Knoten K3 und dem zweiten Knoten K2 geschaltet sein kann (vgl. Fig. 6).

Bei Ausführungsbeispielen kann der Mikrocontroller 202 konfiguriert sein, um in dem Sendemodus

- an dem ersten Knoten K1 das erste Signal (z. B. Sendesignal) anzulegen, und
- an dem zweiten Knoten K2 ein Bezugspotential oder ein zu dem ersten Signal komplementäres Signal anzulegen.

Bei Ausführungsbeispielen kann der Mikrocontroller 202 konfiguriert sein, um in dem Empfangsmodus

- an dem ersten Knoten K1 und dem zweiten Knoten K2 ein Bezugspotential anzulegen, und
- das zweite Signal (z. B. Empfangssignal) an dem dritten Knoten K3 abzugreifen.

Bei Ausführungsbeispielen kann hierzu ein erster Anschluss A1 des Mikrocontrollers 202 direkt mit dem ersten Knoten K1 verbunden sein, wie dies beispielhaft in Fig. 5 gezeigt ist. Natürlich kann der erste Anschluss A1 des Mikrocontrollers 202 auch über ein passives oder aktives Bauteil (z. B. Wiederstand, Kondensator, Verstärker, Komparator, etc.) mit dem ersten Knoten K1 verbunden sein.

Bei Ausführungsbeispielen kann ein zweiter Anschluss A2 des Mikrocontrollers 202 direkt mit dem zweiten Knoten K2 verbunden sein, wie dies beispielhaft in Fig. 5 gezeigt ist. Natürlich kann der zweite Anschluss A2 des Mikrocontrollers 202 auch über ein passives oder aktives Bauteil (z. B. Verstärker, Komparator, etc.) mit dem zweiten Knoten K2 verbunden sein.

Bei Ausführungsbeispielen kann ein dritter Anschluss A3 des Mikrocontrollers 202 direkt mit dem dritten Knoten K3 verbunden sein, wie dies beispielhaft in Fig. 5 gezeigt ist. Natürlich kann der dritte Anschluss A3 des Mikrocontrollers 202 auch über ein passives oder aktives Bauteil (z. B. Verstärker, Komparator, etc.) mit dem dritten Knoten K3 verbunden sein.

Fig. 6 zeigt ein schematisches Blockschaltbild einer Sende-/Empfangsanordnung 200 zum Senden/Empfangen von magnetischen Signalen, gemäß einem weiteren Ausführungsbeispiel der vorliegenden Erfindung. Mit anderen Worten, Fig. 6 zeigt eine schaltungstechnische Umsetzung einer Sende-/Empfangsanordnung 200, die den Schwingkreis 204 zum Senden von Daten als Reihenschwingkreis und zum Empfangen von Daten als Parallelschwingkreis betreibt.

Die Sende-/Empfangsanordnung 200 umfasst den Mikrocontroller 202 und den elektromagnetischen Schwingkreis 204 mit einer Spule L1 und einem Kondensator C1, die zwischen einem ersten Knoten K1 und einem zweiten Knoten K2 geschaltet sind. In Fig. 6 wird hierbei beispielhaft davon ausgegangen, dass die Spule L1 zwischen einem ersten Knoten K1 und einem dritten Knoten K3 geschaltet ist, während der Kondensator C1 zwischen dem dritten Knoten und dem zweiten Knoten geschaltet ist. Spule L1 und Kondensator C1 können natürlich auch vertauscht werden, wie dies oben beschrieben wurde.

Ein erster Anschluss A1 des Mikrocontrollers 202 kann mit dem ersten Knoten K1 des Mikrocontrollers 202 verbunden sein, während ein zweiter Anschluss A2 des Mikrocontrollers 202 mit dem zweiten Knoten K2 verbunden sein kann. Alternativ kann der zweite Knoten K2 auch auf ein Bezugspotential, wie z. B. Masse, geschaltet sein bzw. von dem Mikrocontroller 202 auf das Bezugspotential geschaltet werden, z. B. über einen steuerbaren Schalter. Ein dritter Anschluss A3 des Mikrocontrollers 202 kann hierbei direkt (siehe gestrichelte Linie in Fig. 6) oder über ein aktives Bauteil 320 (z. B. Komparator) mit einem dritten Knoten K3 des elektromagnetischen Schwingkreises 204 verbunden sein.

Im Sendemodus kann der Mikrocontroller 202 konfiguriert sein, um das Sendesignal (bzw. erste Signal) an dem ersten Knoten K1 anzulegen. Sofern der zweite Knoten K2 des Schwingkreises 204 mit dem zweiten Anschluss A2 des Mikrocontrollers 202 verbunden ist, kann der Mikrocontroller 202 im Sendemodus ein Bezugspotential oder ein zum Sendesignal komplementäres Signal an dem zweiten Knoten K2 anlegen.

Im Empfangsmodus kann der Mikrocontroller 202 ein Bezugspotential an dem ersten Knoten K1 des Schwingkreises 204 anlegen und ein Empfangssignal (bzw. zweites Signal) an dem dritten Knoten K3 des Schwingkreises 204 abgreifen. Sofern der zweite Knoten K2 des Schwingkreises 204 mit dem zweiten Anschluss A2 des Mikrocontrollers 202 verbunden ist, kann der Mikrocontroller 202 im Empfangsmodus ein Bezugspotential an dem zweiten Knoten K2 anlegen.

Wie bereits erwähnt kann der dritte Anschluss A3 des Mikrocontrollers 202 über ein aktives Bauteil 230 mit dem dritten Knoten K3 des Schwingkreises 204 verbunden sein. Das aktive Bauteil 230 kann ein Verstärker oder ein Komparator sein, wie dies beispielhaft in Fig. 6 angedeutet ist. Ein erster Eingang des Komparators kann hierbei mit dem dritten Knoten K3 des Schwingkreises 204 verbunden sein, während ein zweiter Eingang des Komparators mit dem ersten Knoten K1 des Schwingkreises verbunden sein kann. Der zweite Eingang des Komparators kann aber auch genauso auf ein Bezugspotential oder ein anderes festes Potential geschaltet sein. Der Ausgang des Komparators kann mit dem dritten Anschluss A3 des Mikrokontrollers verbunden sein.

Wie in Fig. 6 zu erkennen ist, kann der elektromagnetische Schwingkreis 204 optional einen Abstimmkondensator C2-X aufweisen, der zwischen dem dritten Knoten K3 und einem vierten Anschluss A4 des Mikrocontrollers 202 geschaltet ist. Der Mikrocontroller 202 kann hierbei konfiguriert sein, um den elektromagnetischen Schwingkreis 204 durch Schalten des vierten Anschlusses A4 auf einen von zumindest zwei unterschiedlichen Betriebsmodi abzustimmen. Beispielsweise kann der Mikrocontroller 202 zum Abstimmen des elektromagnetischen Schwingkreises 204 den vierten Anschluss A4 auf ein definiertes Bezugspotential schalten, oder an dem vierten Anschluss A4 ein zum ersten Signal (Sendesignal) komplementäres Signal bereitstellen oder den vierten Anschluss A4 auf einen hochohmig Zustand schalten.

Bei Ausführungsbeispielen kann der Mikrocontroller 202 (µC) so konfiguriert sein, dass er im Sendefall am ersten Anschluss A1 (bzw. Pin A1) eine Pulsweitenmodulation (PWM) zur Verfügung stellt, während der zweite Anschluss A2 (Pin A2) auf ein festes Bezugspotential gezogen, oder, für den Fall das der Mikrocontroller 202 eine differenzielle PWM erzeugen kann, den komplementären Ausgang der am ersten Anschluss A1 ausgegebenen PWM bildet. Der Schwingkreis 204 arbeitet in Serienresonanz. Bei Ausführungsbeispielen kann das PWM Signal zwischen dem ersten Anschluss A1 und dem Schwingkreis 204 zusätzlich verstärkt werden (z. B. mittels eines Verstärkers oder CMOS-Inverters), um die Quellimpedanz zu verringern.

Im Empfangsfall kann der Mikrocontroller 202 sowohl den ersten Anschluss A1 als auch den zweiten Anschluss A2 auf ein festes Bezugspotential ziehen, wodurch der Schwingkreis in Parallelresonanz arbeitet. Die Spannung am Knoten zwischen L1 und C1 (= dritter Knoten K3) schwingt nun um das durch den ersten Anschluss A1 bereitgestellte Bezugspotential und kann beispielsweise über einen Komparator 230 an den dritten Anschluss A3 des Mikrocontrollers 202 geführt werden, welcher die empfangenen Daten einliest. Sofern es sich bei dem dritten Anschluss A3 um ein Komparatoreingang des Mikrocontrollers 202 handelt, dann kann die Spannung zwischen L1 und C1 auch direkt an den dritten Anschluss A3 geführt werden.

Bei Ausführungsbeispielen kann der vierte Anschluss A4 (Pin A4) alle Anschlüsse (oder Pins) zusammenfassen, die mit einem Abstimmkondensator C2-X verbunden sind. Über ihn kann im Empfangsfall durch Bereitstellen eines festen Bezugspotentials die Kapazität des Schwingkreises 204 erhöht, oder durch Konfiguration als hochohmiger Eingang gesenkt werden, um damit die Resonanzfrequenz des Schwingkreises 204 zu beeinflussen. Im Sendefall geschieht dies auf die gleiche Weise nur, dass, für den Fall, dass der Mikrocontroller 202 mit einer differenziellen PWM arbeitet, der vierte Anschluss A4 zum Erhöhen der Kapazität zusätzlich zum zweiten Anschluss A2 als komplementärer Ausgang der PWM fungiert.

Bei Ausführungsbeispielen kann derselbe Schwingkreis 204 sowohl zum Empfangen von Daten als auch zum Senden von Daten verwendet werden.

Bei Ausführungsbeispielen kann das signalerzeugende Bauteil (z. B. Mikrocontroller 202) den Schwingkreis 204 zum Senden von Daten als Reihenschwingkreis ansteuern.

Bei Ausführungsbeispielen kann das signalerzeugende Bauteil (z. B. Mikrocontroller 202) den Schwingkreis 204 zum Empfangen von Daten als Parallelschwingkreis konfigurieren.

Bei Ausführungsbeispielen kann das signalerzeugende Bauteil (z. B. Mikrocontroller 202) die Kapazität des Schwingkreises 204 ändern, um die Resonanzfrequenz desselben zu verändern.

Ausführungsbeispiele ermöglichen es durch die Verwendung eines Schwingkreises in Parallel- und Serienresonanz die Reichweite des Kommunikationssystems zu erhöhen, während zusätzlich dazu das Empfangen von Daten möglich bleibt.

Bei Ausführungsbeispielen kann der Mikrocontroller 202 den Schwingkreis 204 mit einer PWM (bzw. einem PWM modulierten Signal) ansteuern.

Bei Ausführungsbeispielen kann der Komparator 230 im Mikrocontroller 202 oder aber auch extern zum Mikrocontroller 202 ausgeführt sein.

Bei Ausführungsbeispielen kann der Mikrocontroller 202 den Schwingkreis 204 direkt Treiben. Alternativ kann bei Ausführungsbeispielen das Steuersignal (oder Sendesignal) mit einer Verstärkerstufe (z. B. CMOS-Inverter, Operationsverstärker) verstärkt werden.

## 2. Parallelschaltung eines Piezoelements zu den Abstimmkondensatoren um bidirektionale Kommunikation über Audio zu ermöglichen

Bei Ausführungsbeispielen kann eine bidirektionale Kommunikation über Audio realisiert werden. Wie in Fig. 6 zu erkennen ist, kann hierzu optional ein Piezoelement 240 parallel zu dem Kondensator C1 (z. B. und dem Kondensator C2-X) an die Spule L1 (bzw. den dritten Knoten K3) und dem fünften Anschluss A5 (z. B. Pin A5) des Mikrocontrollers 202 angeschlossen sein. Soll nun über das Piezoelement 240 gesendet werden, dann kann der Mikrocontroller 202 über den fünften Anschluss A5 ein festes Bezugspotential bereitstellen. Durch die Eigenkapazität des Piezoelements 240 ändert sich jedoch die Resonanzfrequenz des Schwingkreises. Dies kann dadurch kompensiert, dass Kondensatoren der gleichen Kapazität wie der des Piezoelements 240 aus dem Schwingkreis entfernt werden, indem die Pins des Mikrocontrollers mit dem sie verbunden sind, in einen hochohmigen Zustand versetzt werden. Im Empfangsfall kann der Mikrocontroller 202 den fünften Anschluss A5 in einen hochohmigen Zustand versetzen, wodurch das Piezoelement 240 aus dem Schwingkreis entfernt wird, ihm entsprechende Kondensatoren hinzugeschalten und das Empfangen von Daten erfolgt wie in Abschnitt 1 beschrieben über die Spule L1. Dies hat den Vorteil, dass womöglich vorhandene akustische Störquellen ausgeblendet werden.

Als Abstimmkondensator (zur Kompensation des Piezoelements 240) kann bei Ausführungsbeispielen der Abstimmkondensator C2-X oder aber auch ein anderer (zusätzlicher) Abstimmkondensator verwendet werden, der z. B. zwischen dem dritten Knoten K3 und einem Anschluss (z. B. sechsten Anschluss A6) des Mikrocontrollers 202 geschaltet ist.

Bei Ausführungsbeispielen kann das Piezoelement 240 zusätzlich zu dem in Abschnitt 2 beschriebene Verfahren auch direkt angesteuert werden. Dazu kann ein direkt mit dem Piezoelement verbundener Anschluss bzw. Pin des Mikrocontrollers 202 (z. B. der erste Anschluss A1 im Fall ohne externen Komparator) auf ein festes Potential geschaltet werden. Die Anregung kann dann beispielsweise über den fünften Anschluss A5 erfolgen. Vorteil ist, dass dadurch elektromagnetische Störer, die in die Spule L1 einkoppeln, das Sendeverhalten nicht beeinflussen.

Bei Ausführungsbeispielen ist mit demselben Kommunikationssystem bzw. mit derselben Sende-/Empfangseinrichtung sowohl ein Senden über Audio als auch über Magnetfelder möglich.

Bei Ausführungsbeispielen kann eine bidirektionale Kommunikation mit einem handelsüblichen bzw. unmodifiziertem Benutzerendgerät (z. B. Mobiltelefon) durch die Integration eines Piezoelements in die Sende-/Empfangsanordnung ermöglicht werden.

Bei Ausführungsbeispielen wird das Empfangen von Daten bei der bidirektionalen Kommunikation mit einem Mobiltelefon nicht durch akustischen Störquellen beeinflusst.

Bei Ausführungsbeispielen ist der elektromagnetische Schwingkreis mit der Spule L1 und dem Piezoelement (und dem Kondensator C1) abstimmbar.

Bei Ausführungsbeispielen ist das Piezoelement Teil eines abgestimmten Schwingkreises.

Bei Ausführungsbeispielen führt eine Spannungsüberhöhung im Schwingkreis zu einer besseren Ansteuerung des Piezoelements.

Bei Ausführungsbeispielen kann das Piezoelement auch direkt, ohne Schwingkreis angesteuert werden.

Bei Ausführungsbeispielen wird der Sendefall nicht durch magnetische Störer beeinflusst.

## 3. Unsymmetrisches Abstimmen zweier Schwingkreise

In [3] wird eine Möglichkeit beschrieben, die Datenrate des Kommunikationssystems zu erhöhen, indem auch Frequenzen außerhalb der Resonanz der Schwingkreise zur Übermittlung von Daten benutzt werden. Dies hat jedoch den Nachteil, dass außerhalb der Resonanzfrequenz die Reichweite deutlich abnimmt. Eine weitere Möglichkeit die Bandbreite und damit die Datenrate zu erhöhen ist den Schwingkreis ohmsch zu dämpfen, doch auch hier sinkt die Reichweite deutlich.

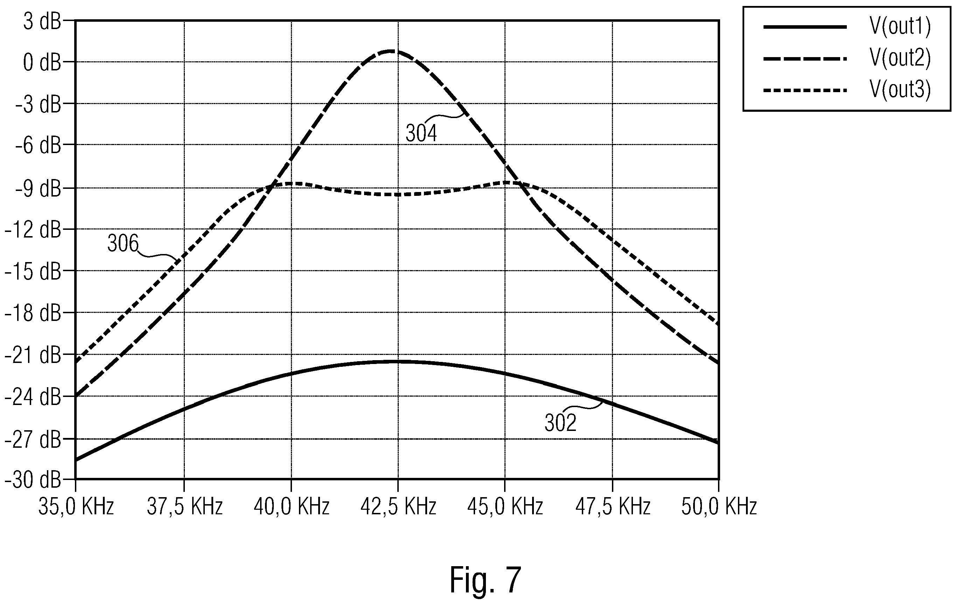

Ausführungsbeispiele schaffen eine Möglichkeit die Bandbreite zu erhöhen ohne die Reichweite stark zu beeinträchtigen. Bei Ausführungsbeispielen werden die zwei miteinander kommunizierenden Schwingkreise, nicht wie bisher auf dieselbe Frequenz abgestimmt, sondern auf zwei leicht voneinander abweichenden Frequenzen, wie dies nachfolgend anhand von Fig. 7 gezeigt wird.

Im Detail zeigt Fig. 7 in einem Diagramm Übertragungsfunktionen verschiedener Kombinationen von Schwingkreisen. Dabei beschreibt die Ordinate die Dämpfung in dB und die Abszisse die Frequenz in kHz. Für eine bessere Vergleichbarkeit werden in Fig. 7 alle drei Beispiele mit derselben idealen Spannungsquelle betrieben. Die Ergebnisse sind im Verhältnis zur Eingangsspannung dargestellt (dB).

In Fig. 7 zeigt hierbei eine dritte Kurve 306 V(out3) eine beispielhafte Übertragungsfunktion zwischen zwei Schwingkreisen, die gem. Ausführungsbeispielen auf zwei leicht voneinander abweichenden Frequenzen abgestimmt sind. Im Detail ist hierbei der Schwingkreis des ersten Geräts auf die obere Modulationsfrequenz von 45 kHz abgestimmt und der Schwingkreis des zweiten Geräts auf die untere Modulationsfrequenz von 40 kHz.

Die zweite Kurve 304 V(out2) zeigt hingegen eine Übertragungsfunktion zwischen zwei Geräten, bei denen die Schwingkreise auf die Trägerfrequenz von 42.5 kHz abgestimmt sind. Hier ist zwar die absolute Signalamplitude höher, jedoch ist die Bandbreite zu gering, um eine Kommunikation mit hoher Datenrate zu ermöglichen.

Die erste Kurve 302 V(out1) beschreibt hingegen eine Übertragungsfunktion zwischen zwei Geräten, bei denen die Schwingkreise auf eine Frequenz abgestimmt sind, wobei die Schwingkreise ohmsch gedämpft sind, um die gleiche Bandbreite wie bei der dritten Kurve 306 V(out3) zu erreichen. Es ist deutlich zu erkennen, dass eine geringe Signalamplitude erzielt wird.

In Kombination mit der Abstimmbarkeit des Kommunikationssystems bzw. der Sende-/Empfangsanordnung aus Abschnitt 1 lässt sich so beispielsweise ein System entwickeln, das beim Verbindungsaufbau die Kommunikation mit identisch abgestimmten Schwingkreisen durchführt, nachdem beide Seiten Kenntnis über die Fähigkeiten des jeweils anderen Teilnehmers haben und das Link Budget ausreichend ist, werden die beiden Schwingkreise auf verschiedene Frequenzen abgestimmt und es kann auf die höhere Datenrate gewechselt werden.

Bei Ausführungsbeispielen können die beiden miteinander kommunizierenden Systeme (oder Schwingkreise) auf zwei voneinander verschiedene Frequenzen abgestimmt werden.

Ausführungsbeispiele ermöglichen eine höhere Datenrate/Bandbreite durch das Abstimmen auf zwei voneinander verschiedener Frequenzen.

Bei Ausführungsbeispielen ist die Reichweite besser als bei zwei Schwingkreisen, die auf die gleiche Frequenz abgestimmt sind, aber zum Erhöhen der Datenrate ohmsch gedämpft werden.

Bei Ausführungsbeispielen erkennen die beiden Kommunikationspartner selbstständig auf welche Frequenz sie sich abstimmen müssen. Indem ein Kommunikationspartner die Sendedatenrate variiert und der Andere die Abstimmung seines Schwingkreises.

### 4. Senden und Empfangen mit einem Reihenschwingkreis

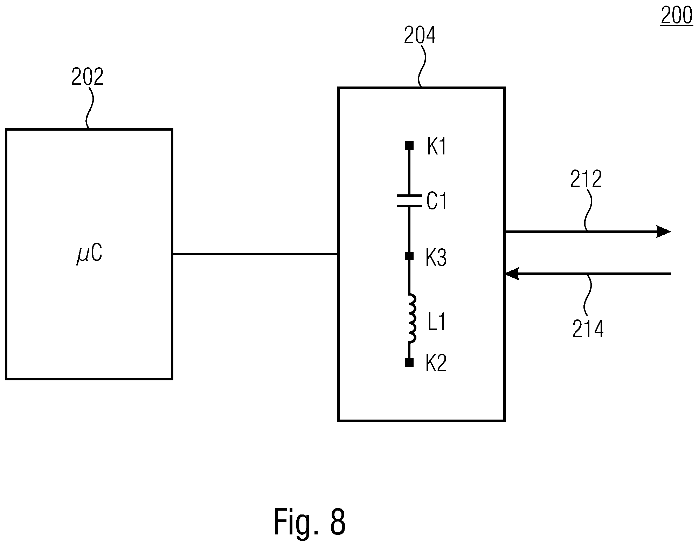

Fig. 8 zeigt ein schematisches Blockschaltbild einer Sende-/Empfangsanordnung 200 zum Senden/Empfangen von magnetischen Signalen, gemäß einem weiteren Ausführungsbeispiel der vorliegenden Erfindung.

Die Sende-/Empfangsanordnung 200 umfasst einen Mikrocontroller 202 und einen elektromagnetischen Schwingkreis 204, wobei der Mikrocontroller 202 mit dem elektromagnetischen Schwingkreis 204 verbunden ist. Der elektromagnetische Schwingkreis 204 kann eine Spule L1 und einen Kondensator C1 aufweisen, die in Reihe geschaltet sind zwischen einem ersten Knoten K1 und einem zweiten Knoten K2, wobei die Spule L1 und der Kondensator C1 über einen dritten Knoten K3 miteinander verbunden sind.

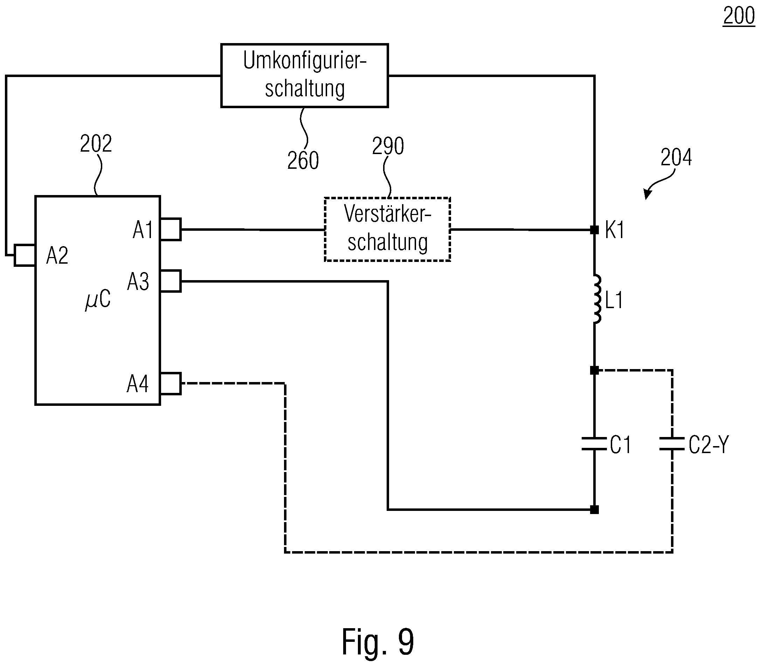

Bei dem in Fig. 8 gezeigten Ausführungsbeispiel wird beispielhaft davon ausgegangen, dass der Kondensator C1 zwischen dem ersten Knoten K1 und dem dritten Knoten K3 geschaltet ist, während die Spule L1 zwischen dem dritten Knoten K3 und dem zweiten Knoten K2 geschaltet ist. Bei Ausführungsbeispielen können der Kondensator C1 und die Spule L1 jedoch genauso andersherum in Reihe zwischen dem ersten Knoten K1 und dem zweiten Knoten K2 geschaltet sein, d.h. die Spule L1 kann zwischen dem ersten Knoten K1 und dem dritten Knoten K3 geschaltet sein, während der Kondensator C1 zwischen dem dritten Knoten K3 und dem zweiten Knoten K2 geschaltet sein kann (vgl. Fig. 9).

Im Sendemodus ist ein erstes Bezugspotential (z. B. Masse) an dem zweiten Knoten K2 angelegt, wobei der Mikrocontroller 202 konfiguriert ist, um ein erstes Signal zum Ansteuern des elektromagnetischen Schwingkreis 204 zu generieren und das generierte erste Signal über den ersten Knoten K1 auf den elektromagnetischen Schwingkreis (z. B. niederohmig) aufzuprägen, um mit dem elektromagnetischen Schwingkreis 204 ein erstes magnetisches Signal 212 (z. B. magnetisches Feld) zu erzeugen, das erste Daten trägt. Beispielsweise kann der erste Knoten K1 hierzu mit einem Anschluss (z. B. ersten Anschluss A1) des Mikrocontrollers verbunden sein.

Beispielsweise kann der zweite Knoten K2 hierzu mit einem Anschluss (z. B. dritten Anschluss) des Mikrocontrollers 202 verbunden sein, wobei der Mikrocontroller 202 konfiguriert ist, um diesen Anschluss auf das erste Bezugspotential zu schalten bzw. an diesem Anschluss das erste Bezugspotential bereitzustellen. Alternativ kann der zweite Knoten K2 auch auf das erste Bezugspotential (z. B. Masse) geschaltet sein bzw. von dem Mikrocontroller 202 auf das Bezugspotential geschaltet werden, z. B. über einen steuerbaren Schalter.

Im Empfangsmodus ist ein zweites Bezugspotential (z. B. Masse) an einem aus dem ersten Knoten K1 und dem zweiten Knoten K2 angelegt, wobei der Mikrocontroller 202 konfiguriert ist, um ein von dem elektromagnetischen Schwingkreis 204 bereitgestelltes zweites Signal, das von einem von dem elektromagnetischen Schwingkreis 204 empfangen zweiten magnetischen Signal 214 (z. B. magnetischen Feld) abhängig ist, über den anderen aus dem ersten Knoten K1 und dem zweiten Knoten K2 (z. B. niederohmig) abzugreifen, um zweite Daten zu erhalten.

Beispielsweise kann einer aus dem ersten Knoten K1 und dem zweiten Knoten K2 hierzu mit einem Anschluss (z. B. dritten Anschluss) des Mikrocontrollers 202 verbunden sein, wobei der Mikrocontroller 202 konfiguriert ist, um diesen Anschluss auf das zweite Bezugspotential zu schalten bzw. an diesem Anschluss das zweite Bezugspotential bereitzustellen. Alternativ kann dieser Knoten auch auf das zweite Bezugspotential (z. B. Masse) geschaltet sein bzw. von dem Mikrocontroller 202 auf das Bezugspotential geschaltet werden, z. B. über einen steuerbaren Schalter.

Beispielsweise kann der andere aus dem ersten Knoten K1 und dem zweiten Knoten K2 hierzu mit einem weiteren Anschluss (z. B. zweiten Anschluss) des Mikrocontrollers 202 verbunden sein, z. B. direkt oder über ein aktives oder passives Bauteil oder über eine Schaltung.

Bei Ausführungsbeispielen bedeutet niederohmig weniger als das doppelte oder fünffache des resistiven Widerstands der Spule des elektromagnetischen Schwingkreises.

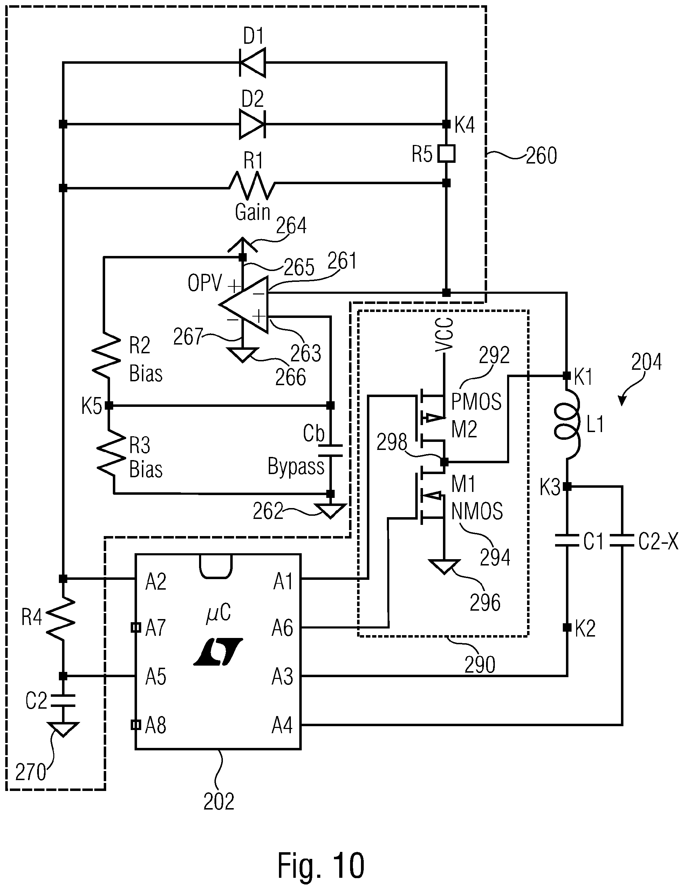

Detaillierte Ausführungsbeispiele der in Fig. 8 gezeigten Sende-/Empfangsanordnung 200 werden nachfolgend anhand der Fig. 9 und 10 näher erläutert.

Fig. 9 zeigt ein schematisches Blockschaltbild einer Sende-/Empfangsanordnung 200 zum Senden/Empfangen von magnetischen Signalen, gemäß einem weiteren Ausführungsbeispiel der vorliegenden Erfindung.

Die Sende-/Empfangsanordnung 200 umfasst den Mikrocontroller 202 und den elektromagnetischen Schwingkreis 204 mit einer Spule L1 und einem Kondensator C1, die zwischen einem ersten Knoten K1 und einem zweiten Knoten K2 geschaltet sind. In Fig. 9 wird hierbei beispielhaft davon ausgegangen, dass die Spule L1 zwischen einem ersten Knoten K1 und einem dritten Knoten K3 geschaltet ist, während der Kondensator C1 zwischen dem dritten Knoten und dem zweiten Knoten geschaltet ist. Spule L1 und Kondensator C1 können natürlich auch vertauscht werden, wie dies oben beschrieben wurde.

Ein erster Anschluss A1 des Mikrocontrollers 202 kann mit dem ersten Knoten K1 des Schwingkreises 204 verbunden sein, beispielsweise direkt oder über eine optionale Verstärkerschaltung 290, wie dies in Fig. 9 angedeutet ist.

Ein zweiter Anschluss A2 des Mikrocontrollers 202 kann über eine Umkonfigurierschaltung 260 mit dem ersten Knoten K1 des Schwingkreises verbunden sein.

Die Umkonfigurierschaltung 260 ist hierbei ausgebildet, um einen Strom in eine proportionale Ausgangsspannung umzuwandeln.

Ein dritter Anschluss A3 des Mikrocontrollers 202 kann mit dem zweiten Knoten K2 des Schwingkreises verbunden sein kann. Alternativ kann der zweite Knoten K2 auch auf ein Bezugspotential, wie z. B. Masse, geschaltet sein bzw. von dem Mikrocontroller 202 auf das Bezugspotential geschaltet werden, z. B. über einen steuerbaren Schalter.

Der Mikrocontroller 202 ist hierbei konfiguriert, um, in einem Sendemodus,

- die Umkonfigurierschaltung 260 beispielsweise zu deaktivieren oder laufen zu lassen, und
- ein erstes Signal zum Ansteuern des elektromagnetischen Schwingkreis 204 zu generieren und den elektromagnetischen Schwingkreis mit dem generierten ersten Signal anzusteuern, um mit dem elektromagnetischen Schwingkreis ein erstes magnetisches Signal zu erzeugen, das erste Daten trägt.

Der Mikrocontroller 202 ist ferner konfiguriert, um, in einem Empfangsmodus,

- die Umkonfigurierschaltung 260 beispielsweise zu aktivieren oder laufen zu lassen, und
- ein von dem elektromagnetischen Schwingkreis 204 bereitgestelltes zweites Signal, das von einem von dem elektromagnetischen Schwingkreis 204 empfangen zweiten magnetischen Signal (z. B. magnetischen Feld) abhängig ist, über die Umkonfigurierschaltung 260 zu erfassen, um zweite Daten zu erhalten.

Bei Ausführungsbeispielen kann die Umkonfigurierschaltung 260 ein Strom-Spannungs-Wandler oder ein niederohmiger Verstärker sein. Beispielsweise kann der niederohmiger Verstärker ein Transimpedanzverstärker oder ein als Transimpedanzverstärker verschalteter Operationsverstärker sein.

Wie in Fig. 9 zu erkennen ist, kann der elektromagnetische Schwingkreis 204 optional einen Abstimmkondensator C2-X aufweisen, der zwischen dem dritten Knoten K3 und einem vierten Anschluss A4 des Mikrocontrollers 202 geschaltet ist. Der Mikrocontroller 202 kann hierbei konfiguriert sein, um den elektromagnetischen Schwingkreis 204 durch Schalten des vierten Anschlusses A4 auf einen von zumindest zwei unterschiedlichen Betriebsmodi abzustimmen. Beispielsweise kann der Mikrocontroller 202 zum Abstimmen des elektromagnetischen Schwingkreises 204 den vierten Anschluss A4 auf ein definiertes Bezugspotential schalten, oder an dem vierten Anschluss A4 ein zum ersten Signal (Sendesignal) komplementäres Signal bereitstellen oder den vierten Anschluss A4 auf einen hochohmig Zustand schalten.

Ausführungsbeispiele der Umkonfigurierschaltung 260 und der Verstärkerschaltung 290 werden nachfolgend anhand von Fig. 10 erläutert.

Im Detail zeigt Fig. 10 ein schematisches Blockschaltbild einer beispielhaften Implementierung der in Fig. 9 gezeigten Sende-/Empfangsanordnung, gemäß einem Ausführungsbeispiel der vorliegenden Erfindung.

Wie in Fig. 10 zu erkennen ist, kann die Umkonfigurierschaltung 260 ein als Transimpedanzverstärker verschalteten Operationsverstärker sein, der wie im Folgenden beschrieben verschaltet sein kann.

Bei Ausführungsbeispielen kann ein erster Eingang 261 des Operationsverstärkers OPV mit dem ersten Knoten K1 verbunden sein.

Bei Ausführungsbeispielen kann ein zweiter Eingang 263 des Operationsverstärkers OPV über einen Überbrückungskondensator Cb mit einem Bezugspotentialanschluss 262 (z. B. Masseanschluss) verbunden sein.

Bei Ausführungsbeispielen kann ein Ausgang des Operationsverstärkers OPV mit dem zweiten Anschluss A2 des Mikrocontrollers 202 verbunden sein.

Bei Ausführungsbeispielen kann ein erster Wiederstand R1 in Reihe geschaltet sein zwischen dem ersten Knoten K1 und dem zweiten Anschluss A2 des Mikrocontrollers 202.

Bei Ausführungsbeispielen kann eine erste Diode D1 in Durchlassrichtung geschaltet sein zwischen dem ersten Knoten K1 und dem zweiten Anschluss A2 des Mikrocontrollers 202.

Bei Ausführungsbeispielen kann eine zweite Diode D2 in Sperrrichtung geschaltet sein zwischen dem ersten Knoten K1 und dem zweiten Anschluss A2 des Mikrocontrollers 202.

Bei Ausführungsbeispielen kann ein fünfter Wiederstand R5 in Reihe zwischen einem vierten Knoten K4 und dem ersten Knoten K4 geschaltet sein, wobei die erste Diode D1 und die zweite Diode D2 über den fünften Wiederstand R5 mit dem ersten Knoten K1 verbunden sind. Hierbei kann ein Widerstandswert des fünften Wiederstands R5 kleiner sein als Widerstandswert des ersten Wiederstands R1.

Bei Ausführungsbeispielen kann ein erster Versorgungsanschluss 265 des Operationsverstärkers OPV mit einem Versorgungsspannungsanschluss 264 verbunden sein.

Bei Ausführungsbeispielen kann ein zweiter Versorgungsanschluss 267 des Operationsverstärkers OPV mit einem Bezugspotentialanschluss 266 (z. B. Masseanschluss) verbunden sein.

Bei Ausführungsbeispielen kann der erste Versorgungsanschluss 264 über zwei in Reihe geschaltete Wiederstände R2 und R3 mit dem Bezugspotentialanschluss 262 (z. B. Masseanschluss) verbunden sein.

Bei Ausführungsbeispielen kann ein Knoten K5 zwischen den zwei in Reiche geschalteten Wiederständen R2 und R3 mit dem zweiten Eingang 263 des Operationsverstärkers OPV verbunden sein.

Bei Ausführungsbeispielen kann der zweite Anschluss A2 des Mikrocontrollers 202 mit einem fünften Anschluss A5 des Mikrocontrollers über einen vierten Wiederstand R4 verbunden sein.

Bei Ausführungsbeispielen kann der fünfte Anschluss A5 des Mikrocontrollers 202 über einen zweiten Kondensator C2 mit einem Bezugspotentialanschluss 270 (z. B. Masseanschluss) verbunden sein.

Wie in Fig. 10 ferner zu erkennen ist, kann die Verstärkerschaltung 290 bei Ausführungsbeispielen einen ersten elektronischen Schalter 292 und einen zweiten elektronischen Schalter 294 aufweisen, die in Reihe geschaltet sind zwischen einem Versorgungsspannungsanschluss VCC und einem Bezugspotentialanschluss 296, wobei ein Ausgangsanschluss 298 der Verstärkerschaltung 290 zwischen dem ersten elektronischen Schalter 292 und dem zweiten elektronischen Schalter 294 mit dem ersten Knoten K1 verbunden ist. Bei Ausführungsbeispielen können die elektronischen Schalter Bipolartransistoren oder Feldeffekttransistoren sein, wie z. B. ein PMOS (p-Kanal-MOSFET) und ein NMOS (n-Kanal-MOSFET), wie dies beispielhaft in Fig. 10 gezeigt ist.

Bei Ausführungsbeispielen kann der Mikrocontroller 202 konfiguriert sein, um, in dem Sendemodus, über die Verstärkerschaltung 290 ein pulsweitenmoduliertes erstes Signal an dem ersten Knoten K1 anzulegen. Hierzu kann ein erster Anschluss A1 des Mikrocontrollers 202 beispielsweise mit einem Steueranschluss (z. B. Basis oder Gate) des ersten elektronischen Schalters 292 verbunden sein, während ein sechster Anschluss A6 des Mikrocontrollers 202 beispielsweise mit einem Steueranschluss (z. B. Basis oder Gate) des zweiten elektronischen Schalters 294 verbunden sein kann.

Bei Ausführungsbeispielen können der erste elektronische Schalter 292 und der zweite elektronische Schalter 294 so geschalten sein, dass der erste elektronische Schalter 292 und der zweite elektronische Schalter 294 hochohmig sind. Beispielsweise kann im Falle von einem PMOS und einem NMOS, wie dies in Fig. 10 gezeigt ist, der Mikrocontroller 202 an dem sechsten Anschluss eine niedrige Spannung für den NMOS bereitstellen und an dem ersten Anschluss A1 eine hohe Spannung für den PMOS.

Bei Ausführungsbeispielen kann also die in Fig. 6 gezeigte Schaltung auch dazu verwendet werden, um von einem Reihenschwingkreis zu einem Reihenschwingkreis zu senden. Dazu kann wie in Fig. 10 gezeigt der Komparator aus Fig. 6 durch die Umkonfigurierschaltung 290 (z. B. einen als Transimpedanzverstärker verschalteten Operationsverstärker (OPV)) ersetzt werden.

Im Sendefall arbeitet die Schaltung wie oben beschrieben. Über den dritten Anschluss A3 und den vierten Anschluss A4 des Mikrocontrollers 202 kann der Schwingkreis 204 abgestimmt werden und über den ersten Anschluss A1 und den sechsten Anschluss A6 zum Schwingen angeregt werden. Der Operationsverstärker OPV kann deaktiviert sein.

Im Empfangsfall kann der Operationsverstärker OPV aktiviert und der dritte Anschluss A3 und der vierte Anschluss A4 auf ein festes Bezugspotential geschalten (z. B. Masse) werden. So lange der Operationsverstärker OPV nicht übersteuert ist die Spannung zwischen dessen Eingängen gleich Null und die Verbindung stellt einen virtuellen Kurzschluss dar und der Schwingkreis 204 schwingt in Serienresonanz.

Damit die Spannung zwischen den beiden Eingängen 261 und 263 des Operationsverstärker OPV, unabhängig von dem in der Spule L1 induzierten Strom $I_L$ gleich null ist, regelt der Operationsverstärker OPV die Spannung am zweiten Anschluss A2 des Mikrocontrollers 202 zu:

$$U_{Pin\,2} = -I_L * R_{Gain} + U_{Bias}$$

wobei $U_{Bias}$ die durch das Verhältnis der Widerstände R2 und R3 definierte Spannung am Eingang 263 des Operationsverstärkers OVP.

Sind der zweite Anschluss A2 und der fünfte Anschluss A5 des Mikrocontrollers 202 Komparatoreingänge, dann können diese das empfangene Signal bereits mit geringer Verstärkung einlesen. Wird der erste Widerstand R1 bzw. R_Gain soweit erhöht, dass der Operationsverstärker OPV bereits bei sehr kleinen Eingangssignalen übersteuert, ist es auch möglich mittels eines normalen digitalen Eingangs das Empfangssignal einzulesen.

Die beiden MOSFETS 292 und 294 dienen dazu die Treiberimpedanz im Sendefall zu verringern und um mehr Strom durch die Spule L1 treiben zu können.

Das in Fig. 10 gezeigte Ausführungsbeispiel hat den Vorteil, dass das eingelesene Signal nur von dem in die Empfangsspule L1 induzierten Strom abhängt. Und die Treiberleistung des Operationsverstärkers OPV auf der Platine vorhandene, externe Störungen, Schwankungen der Versorgungspannung und interne Schaltflanken effizient unterdrückt.

Bei Ausführungsbeispielen wird der serielle Schwingkreis zum Senden und zum Empfangen von Signalen verwendet.

Bei Ausführungsbeispielen ist die Sende-/Empfangsanordnung (bzw. die Schaltung der Sende-/Empfangsanordnung) konfiguriert, um das Empfangssignal als Stromfluss in einem Serienschwingkreis zu messen.

Bei Ausführungsbeispielen können die Signale von einem beliebigen Schwingkreis empfangen werden. Mit dieser Schaltung ist es daher auch möglich von einem Serien- zu einem Parallelschwingkreis zu senden.

Bei Ausführungsbeispielen wird ein Verstärker mit einem niedrigem Eingangswiderstand verwendet ($R_{in}$ < $R_{Spule}$, z. B. Transimpedanzverstärker), wodurch die Verwendung eines Serienschwingkreises (zum Empfangen) erst möglich wird.

Ausführungsbeispiele der hierin beschriebenen Sende-/Empfangsanordnung sind weniger anfällig für kapazitiv eingekoppelte Störungen.

Ausführungsbeispiele der hierin beschriebenen Sende-/Empfangsanordnung (bzw. der Schaltung der Sende-/Empfangsanordnung) ermöglichen ein deutlich höheres Empfangssignal im Spannungsbereich als es ein vergleichbarer Parallelschwingkreis erzeugen würde.

Ausführungsbeispiele der hierin beschriebenen Sende-/Empfangsanordnung haben den Vorteil, dass durch das größere Empfangssignal die Empfindlichkeit verbessert wird da interne Komparatoren meist einen vergleichsweise großen Offset haben.

Bei Ausführungsbeispielen wird durch die Verwendung zweier MOSFETs das Sendesignal verstärkt.

Bei Ausführungsbeispielen sind keine Komparatoren nötig, wenn die Verstärkung ausreichend groß ist.

Bei Ausführungsbeispielen kann von einem Serienschwingkreis zu einem Parallelschwingkreis gesendet werden und von einem Parallelschwingkreis mit einem Serienschwingkreis empfangen werden, oder von einem Serienschwingkreis mit einem Serienschwingkreis empfangen werden.

Bei Ausführungsbeispielen kann der Komparator intern oder extern ausgeführt werden. Bei Ausführungsbeispielen kann auf den Komparator auch verzichtet werden.

5. Weitere Ausführungsbeispiele

Ausführungsbeispiele der vorliegenden Erfindung schaffen ein preisgünstiges und allgemein verfügbares Konzept, Geräte, vor allem Sensorknoten, zu konfigurieren bzw. im Rahmen von Serviceapplikationen auszulesen und ggf. zu konfigurieren.

Ausführungsbeispiele spezifizieren eine Hardwarekonfiguration der Sende-/Empfangsanordnung und ermöglichen eine höhere Reichweite und Datenrate für die bidirektionale Kommunikation mit einem Schwingkreis, und/oder eine bidirektionale Kommunikation über Schall.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger, das digitale Speichermedium oder das computerlesbare Medium sind typischerweise gegenständlich und/oder nichtvergänglich bzw. nichtvorübergehend.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Literaturverzeichnis

[1] DE102018212957B3
[2] DE102018214716A1
[3] DE102019201152B3
[4] DE102019206848B3
[5] DE102019206836A1
[6] DE102019220227A1
[7] DE102020208155A1

**Patentansprüche**

1. Sende-/Empfangsanordnung (200) zum Senden/Empfangen von magnetischen Signalen, wobei die Sende-/Empfangsanordnung (200) folgende Merkmalen aufweist:

   einen Mikrocontroller (202), und
   einen elektromagnetischen Schwingkreis (204), wobei der Mikrocontroller (202) mit dem elektromagnetischen Schwingkreis (204) verbunden ist,
   wobei der Mikrocontroller (202) konfiguriert ist, um, in einem Sendemodus,

   - den elektromagnetischen Schwingkreis (204) in Serienresonanz zu betreiben, und
   - ein erstes Signal zum Ansteuern des elektromagnetischen Schwingkreis (204) zu generieren und den elektromagnetischen Schwingkreis (204) mit dem generierten ersten Signal anzusteuern, um mit dem elektromagnetischen Schwingkreis (204) ein erstes magnetisches Signal (212) zu erzeugen, das erste Daten trägt,

   wobei der Mikrocontroller (202) konfiguriert ist, um, in einem Empfangsmodus,

   - den elektromagnetischen Schwingkreis (204) in Serienresonanz zu betreiben, und
   - ein von dem elektromagnetischen Schwingkreis (204) bereitgestelltes zweites Signal auszuwerten, das von einem von dem elektromagnetischen Schwingkreis (204) detektierten zweiten magnetischen Signal (214) abhängig ist, um zweite Daten zu empfangen.

2. Sende-/Empfangsanordnung (200) nach Anspruch 1,

   wobei der elektromagnetische Schwingkreis (204) eine Spule (L1) und einen Kondensator (C1) aufweist, die in Reihe geschaltet sind zwischen einem ersten Knoten (K1) und einem zweiten Knoten (K2),
   wobei in einem Sendemodus

   - ein erstes Bezugspotential an dem zweiten Knoten (K2) angelegt ist, und
   - der Mikrocontroller (202) konfiguriert ist, um ein erstes Signal zum Ansteuern des elektromagnetischen Schwingkreis (204) zu generieren und das generierte erste Signal über den ersten Knoten (K1) auf den elektromagnetischen Schwingkreis (204) aufzuprägen, um mit dem elektromagnetischen Schwingkreis (204) ein erstes magnetisches Signal (212) zu erzeugen, das erste Daten trägt,

   wobei in einem Empfangsmodus,

   - ein zweites Bezugspotential an dem ersten Knoten (K1) oder zweiten Knoten (K2) angelegt ist, und
   - ein von dem elektromagnetischen Schwingkreis (204) bereitgestelltes zweites Signal, das von einem von dem elektromagnetischen Schwingkreis (204) empfangen zweiten magnetischen Signal (214) abhängig ist, über den ersten Knoten (K1) oder zweiten Knoten (K2) abzugreifen, um zweite Daten zu erhalten.

3. Sende-/Empfangsanordnung (200) nach Anspruch 2,

   wobei der Mikrocontroller (202) mit dem elektromagnetischen Schwingkreis (204) über eine Umkonfigurierschaltung (260) verbunden ist,
   wobei der Mikrocontroller (202) konfiguriert ist, um, in einem Sendemodus,

   - ein erstes Signal zum Ansteuern des elektromagnetischen Schwingkreis (204) zu generieren und den elektromagnetischen Schwingkreis (204) mit dem generierten ersten Signal anzusteuern, um mit dem elektromagnetischen Schwingkreis (204) ein erstes magnetisches Signal zu erzeugen, das erste Daten trägt,

wobei der Mikrocontroller (202) konfiguriert ist, um, in einem Empfangsmodus,

- ein von dem elektromagnetischen Schwingkreis (204) bereitgestelltes zweites Signal, das von einem von dem elektromagnetischen Schwingkreis (204) empfangen zweiten magnetischen Signal abhängig ist, über die Umkonfigurierschaltung (260) zu erfassen, um zweite Daten zu erhalten,

wobei die Umkonfigurierschaltung (260) ausgebildet ist, um einen Strom in eine Ausgangsspannung umzuwandeln.

4. Sende-/Empfangsanordnung (200) nach Anspruch 3,
wobei die Umkonfigurierschaltung (260) ein Strom-Spannungs-Wandler oder ein niederohmiger Verstärker ist.

5. Sende-/Empfangsanordnung (200) nach Anspruch 4,
wobei der niederohmiger Verstärker ein Transimpedanzverstärker oder ein als Transimpedanzverstärker verschalteter Operationsverstärker (OPV) ist.

6. Sende-/Empfangsanordnung (200) nach einem der Ansprüche 1 bis 5,

wobei der elektromagnetische Schwingkreis (204) eine Spule (L1) und einen Kondensator (C1) aufweist, die in Reihe geschaltet sind zwischen einem ersten Knoten (K1) und einem zweiten Knoten (K2),
wobei die Spule (L1) und der Kondensator (C1) über einen dritten Knoten (K3) miteinander verbunden sind.

7. Sende-/Empfangsanordnung (200) nach Anspruch 6,

wobei der Mikrocontroller (202) konfiguriert ist, um, in dem Sendemodus, an dem ersten Knoten (K1) das erste Signal anzulegen,
und/oder wobei der Mikrocontroller (202) konfiguriert ist, um, in dem Sendemodus, an dem zweiten Knoten (K2) ein Bezugspotential oder ein zu dem ersten Signal komplementäres Signal anzulegen,
und/oder wobei der Mikrocontroller (202) konfiguriert ist, um, in dem Empfangsmodus, an dem zweiten Konten (K2) ein Bezugspotential anzulegen.

8. Sende-/Empfangsanordnung (200) nach einem der Ansprüche 6 bis 7,

wobei ein erster Anschluss (A1) des Mikrocontrollers (202) mit dem ersten Knoten (K1) verbunden ist, wobei ein zweiter Anschluss (A2) des Mikrocontrollers über den als Transimpedanzverstärker verschalteten Operationsverstärker (OPV) mit dem ersten Knoten (K1) verbunden ist,
und/oder wobei der zweite Knoten (K2) mit einem dritten Anschluss (A3) des Mikrocontrollers (202) oder einem Bezugspotentialanschluss verbunden ist.

9. Sende-/Empfangsanordnung (200) nach einem der Ansprüche 6 bis 8,

wobei der elektromagnetische Schwingkreis (204) ferner einen Abstimmkondensator (C2-X) aufweist, der zwischen dem dritten Knoten (K3) und einem vierten Anschluss (A4) des Mikrocontrollers (202) geschaltet ist,
wobei der Mikrocontroller (202) konfiguriert ist, um den elektromagnetischen Schwingkreis (204) durch Schalten des vierten Anschlusses (A4) auf einen von zumindest zwei unterschiedlichen Betriebsmodi abzustimmen.

10. Sende-/Empfangsanordnung (200) nach einem der Ansprüche 5 bis 8,
wobei der als Transimpedanzverstärker verschaltete Operationsverstärker (OPV) wie folgt verschaltet ist:

ein erster Eingang (261) des Operationsverstärkers (OPV) ist mit dem ersten Knoten (K1) verbunden,
wobei ein zweiter Eingang (263) des Operationsverstärkers (OPV) ist über einen Überbrückungskondensator (Cb) mit einem Bezugspotentialanschluss (262) verbunden,
wobei ein Ausgang des Operationsverstärkers (OPV) ist mit dem zweiten Anschluss (A2) des Mikrocontrollers (202) verbunden,
wobei ein erster Wiederstand (R1) in Reihe geschaltet ist zwischen dem ersten Knoten (K1) und dem zweiten Anschluss (A2) des Mikrocontrollers (202),
wobei eine erste Diode (D1) in Durchlassrichtung geschaltet ist zwischen dem ersten Knoten (K1) und dem zweiten Anschluss (A2) des Mikrocontrollers (202),
wobei eine zweite Diode (D2) in Sperrrichtung geschaltet ist zwischen dem ersten Knoten (K1) und dem zweiten Anschluss (A2) des Mikrocontrollers (202), wobei ein erster Versorgungsanschluss (265) des Operationsverstärkers (OPV) mit einem Versorgungsspannungsanschluss (264) verbunden ist,
wobei ein zweiter Versorgungsanschluss (267) des Operationsverstärkers mit einem Bezugspotentialanschluss (266) verbunden ist,
wobei der erste Versorgungsanschluss (261) über zwei in Reihe geschaltete Wiederstände (R2, R3) mit dem Bezugspotentialanschluss (262) verbunden ist,
wobei ein Knoten (K5) zwischen den zwei in Reihe geschalteten Wiederständen (R2, R3) mit dem zweiten Eingang (263) des Operationsverstärkers (OPV) verbunden ist,
wobei der zweite Anschluss (A2) des Mikrocontrollers (202) mit einem fünften Anschluss (A5) des Mikrocontrollers (202) über einen vierten Wiederstand (R4) verbunden ist,
wobei der fünfte Anschluss (A5) des Mikrocontrollers (202) über einen zweiten Kondensator (C2) mit einem Bezugspotentialanschluss (270) verbunden ist.

11. Sende-/Empfangsanordnung (200) nach Anspruch 10,

wobei der Operationsverstärker (OPV) konfiguriert ist, um, in dem Empfangsmodus, eine an dem Ausgang bereitgestellt Spannung $U_{Ausgang}$ basierend auf der folgenden Formel zu regeln:

$$U_{Ausgang} = -I_L \cdot R1 + U_{Eingang\ 2}$$

wobei $I_L$ der durch die Spule (L1) des elektromagnetischen Schwingkreises (204) fließende Strom ist, wobei R1 der Widerstandswert des ersten Wiederstands (R1) ist, und wobei $U_{Eingang\ 2}$ eine an dem zweiten Eingang (263) des Operationsverstärkers (OPV) anliegende Spannung ist.

12. Sende-/Empfangsanordnung (200) nach einem der Ansprüche 10 bis 11,
wobei der zweite Anschluss (A2) und der fünfte Anschluss (A5) des Mikrocontrollers (202) Komparatoreingänge sind.

13. Sende-/Empfangsanordnung (200) nach einem der Ansprüche 6 bis 12,

wobei der erste Anschluss (A1) des Mikrocontrollers (202) mit dem ersten Knoten (K1) verbunden ist,
oder wobei der erste Anschluss (A1) des Mikrocontrollers (202) über eine Verstärkerschaltung (290) mit dem ersten Knoten (K1) verbunden ist.

14. Sende-/Empfangsanordnung (200) nach Anspruch 13,

wobei die Verstärkerschaltung (290) einen ersten elektronischen Schalter (292) und einen zweiten elektronischen Schalter (294) aufweist, die in Reihe geschaltet sind zwischen einem Versorgungsspannungsanschluss (VCC) und einem Bezugspotentialanschluss (296), wobei ein Ausgangsanschluss (298) der Verstärkerschaltung zwischen dem ersten elektronischen Schalter (292) und dem zweiten elektronischen Schalter (294) mit dem ersten Knoten (K1) verbunden ist,
wobei der Mikrocontroller (202) konfiguriert ist, um, in dem Sendemodus, über die Verstärkerschaltung (290) ein pulsweitenmoduliertes erstes Signal an dem ersten Knoten (K1) anzulegen.

15. Gerät, mit folgenden Merkmalen:

einer Konfigurations- und/oder Bedienschnittstelle zum Konfigurieren und/oder Bedienen des Geräts,
wobei die Konfigurations- und/oder Bedienschnittstelle eine Sende-/Empfangsanordnung (200) nach einem der Ansprüche 1 bis 14 aufweist.

Fig. 1

EP 4 391 399 A1

Fig. 2a

EP 4 391 399 A1

Fig. 2b

EP 4 391 399 A1

Fig. 2c

Fig. 3

EP 4 391 399 A1

Fig. 4

EP 4 391 399 A1

EP 4 391 399 A1

Fig. 5

Fig. 6

EP 4 391 399 A1

Fig. 7

Fig. 8

Fig. 9

Fig. 10

Europäisches
Patentamt

European
Patent Office

Office européen
des brevets

# EUROPÄISCHER RECHERCHENBERICHT

**Nummer der Anmeldung**

**EP 23 21 9215**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2007/041601 A1 (ESSABAR MOHAMAD [DK]) 22. Februar 2007 (2007-02-22) | 1-8, 13-15 | INV. H04B5/26 |
| Y | * Zusammenfassung * | 9 | H04B5/48 |
| A | * Absätze [0019], [0020], [0100] - [0122] * | 10-12 | H04B5/77 H04B5/79 |
|   | * Abbildungen 1-4 * | | |
|   | ----- | | |
| X | US 2021/194284 A1 (VAN WAGENINGEN ANDRIES [NL] ET AL) 24. Juni 2021 (2021-06-24) | 1-8, 13-15 | |
| Y | * Zusammenfassung * | 9 | |
| A | * Absätze [0001], [0024] - [0030] * | 10-12 | |
|   | * Abbildungen 1-3 * | | |
|   | ----- | | |
| Y | US 2005/111682 A1 (ESSABAR MOHAMAD [DK] ET AL) 26. Mai 2005 (2005-05-26) | 9 | |
| A | * Zusammenfassung * | 1-8, 10-15 | |
|   | * Absätze [0001], [0040] * | | |
|   | * Abbildung 3 * | | |
|   | ----- | | |

**RECHERCHIERTE SACHGEBIETE (IPC)**

**H04B**

Der vorliegende Recherchenbericht wurde für alle Patentansprüche erstellt

| Recherchenort | Abschlußdatum der Recherche | Prüfer |
|---|---|---|
| **München** | **6. Mai 2024** | **Helms, Jochen** |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 21 9215

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-05-2024

| Im Recherchenbericht angeführtes Patentdokument | Datum der Veröffentlichung | Mitglied(er) der Patentfamilie | | Datum der Veröffentlichung |
|---|---|---|---|---|
| US 2007041601 A1 | 22-02-2007 | AT | E472860 T1 | 15-07-2010 |
| | | CN | 1921331 A | 28-02-2007 |
| | | DK | 1758261 T3 | 18-10-2010 |
| | | DK | 2226951 T3 | 27-03-2017 |
| | | EP | 1758261 A1 | 28-02-2007 |
| | | EP | 2226951 A2 | 08-09-2010 |
| | | US | 2007041601 A1 | 22-02-2007 |
| US 2021194284 A1 | 24-06-2021 | CN | 108702034 A | 23-10-2018 |
| | | EP | 3420629 A1 | 02-01-2019 |
| | | JP | 6509450 B2 | 08-05-2019 |
| | | JP | 2019506129 A | 28-02-2019 |
| | | US | 2021194284 A1 | 24-06-2021 |
| | | WO | 2017144387 A1 | 31-08-2017 |
| US 2005111682 A1 | 26-05-2005 | AT | E373401 T1 | 15-09-2007 |
| | | CA | 2547414 A1 | 16-06-2005 |
| | | CN | 101002504 A | 18-07-2007 |
| | | DE | 602004008962 T2 | 29-05-2008 |
| | | DK | 1688016 T3 | 05-11-2007 |
| | | EP | 1688016 A1 | 09-08-2006 |
| | | US | 2005111682 A1 | 26-05-2005 |
| | | WO | 2005055654 A1 | 16-06-2005 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102018212957 B3
- DE 102018214716 A1
- DE 102019201152 B3
- DE 102019206848 B3
- DE 102019206836 A1
- DE 102019220227 A1
- DE 102020208155 A1